# EUROPEAN PATENT SPECIFICATION

(11) **EP 3 866 203 B1**
(45) Date of publication and mention of the grant of the patent: **07.10.2026**
(21) Application number: 19872162.3
(22) Date of filing: 10.04.2019
(51) Int. Cl.: H10H 29/01, H10H 29/37, H10H 29/41, H10H 29/20

(54) **LIGHT-EMITTING DEVICE, MANUFACTURING METHOD THEREFOR, AND DISPLAY DEVICE COMPRISING SAME**
LICHTEMITTIERENDE VORRICHTUNG, HERSTELLUNGSVERFAHREN DAFÜR UND ANZEIGEVORRICHTUNG DAMIT
DISPOSITIF ÉLECTROLUMINESCENT, SON PROCÉDÉ DE FABRICATION ET DISPOSITIF D'AFFICHAGE LE COMPRENANT

(30) Priority: 11.10.2018 KR 20180121409
(43) Date of publication of application: 18.08.2021
(73) Proprietor: Samsung Display Co., Ltd., Yongin-si, Gyeonggi-Do 17113 (KR)
(72) Inventor: LI, Xinxing, Yongin-si, Gyeonggi-do 17113 (KR); KONG, Tae Jin, Yongin-si, Gyeonggi-do 17113 (KR); LEE, Hee Keun, Yongin-si, Gyeonggi-do 17113 (KR); KIM, Dae Hyun, Yongin-si, Gyeonggi-do 17113 (KR); CHO, Hyun Min, Yongin-si, Gyeonggi-do 17113 (KR); TAE, Chang Il, Yongin-si, Gyeonggi-do 17113 (KR)
(74) Representative: Marks & Clerk LLP
(86) International application number: PCT/KR2019/004292
(87) International publication number: WO 2020/075935

(56) References cited:
- JP-A- 2005 136 142
- KR-A- 20160 087 265
- KR-A- 20170 026 956
- KR-A- 20180 072 909
- US-A1- 2018 122 836
- US-A1- 2018 175 106
- US-A1- 2018 197 899
- US-A1- 2018 198 018
- US-B1- 9 443 904

## Description

### Technical Field

Various embodiments of the present disclosure relate to a light emitting device, a method of fabricating the light emitting device, and a display device having the light emitting device.

### Background Art

Recently, technologies of manufacturing a subminiature light emitting diode using a material having a reliable inorganic crystal structure and manufacturing a light emitting device using the light emitting diode have been developed. For example, the technologies of manufacturing subminiature light emitting diodes having a small size in a range from the nanoscale to the microscale, and forming a light source of a light emitting device using the subminiature light emitting diodes have been developed. Such a light emitting device may be provided in various electronic devices such as a display device and a lighting device.

US2018/122836 A1 discloses a light emitting diode display device. US2018/0175106 A1 discloses a light emitting device, including: a substrate; a light emitting element on the substrate; one or more partition walls disposed on the substrate, the one or more partition walls being spaced apart from the light emitting element; a first and second reflection electrode adjacent to a first and second end portion of the light emitting element; a first contact electrode connected to the first reflection electrode and the first end portion of the light emitting element; an insulating layer on the first contact electrode, having an opening exposing the second end portion of the light emitting element; and a second contact electrode on the insulating layer.

### Disclosure

### Technical Problem

Various embodiments of the present disclosure relate to a light emitting device including a light emitting diode, a method of fabricating the light emitting device, and a display device including the light emitting device.

### Technical Solution

According to an aspect of the present disclosure, a light emitting device is provided in accordance with claim 1.

According to the invention, the light emitting device further includes: a first partition wall disposed between the substrate and one area of the first electrode; and a second partition wall disposed between the substrate and one area of the second electrode.

In an embodiment, the first partition wall and the second partition wall may be disposed on a same layer on the substrate. One area of the first insulating layer may be interposed between the second partition wall and the second electrode.

In an embodiment, the light emitting device may include a display element layer including the first electrode, the second electrode, and the light emitting diode, and a circuit element layer disposed between the display element layer and the substrate. The circuit element layer may include: a first circuit element or a first power line electrically connected to the first electrode, and including one area overlapping the second electrode; and a second circuit element or a second power line electrically connected to the second electrode, and including one area overlapping the first electrode.

In an embodiment, an overlapping surface area between the first circuit element or the first power line and the second electrode may be greater than an overlapping surface area between the second circuit element or the second power line and the first electrode.

In an embodiment, the first insulating layer may include an opening in which one area of the first electrode is exposed. The first contact electrode may contact the exposed one area of the first electrode and the first end of the light emitting diode.

In an embodiment, the light emitting device may further include a second insulating layer disposed on the second contact electrode and configured to cover the second contact electrode. One end of the second insulating layer may be interposed between the first contact electrode and the second contact electrode.

In an embodiment, the light emitting device may further include a third insulating layer disposed on one area of the second electrode.

In an embodiment, the light emitting device may further include at least one of: a fourth insulating layer disposed on the first electrode, the second electrode, and one area of the light emitting diode; and a fifth insulating layer configured to cover the first contact electrode and including one end interposed between the first contact electrode and the second contact electrode.

In an embodiment, the light emitting device may further include a sixth insulating layer partially disposed on the first electrode, the second electrode, and one area of the light emitting diode, and configured to expose one area of each of the first electrode and the second electrode, and the first end and the second end of the light emitting diode.

In an embodiment, one end of the first contact electrode may be disposed on one area of the sixth insulating layer that is disposed on the light emitting diode. One end of the second contact electrode may be disposed, to face the first contact electrode, on the one area of the sixth insulating layer that is disposed on the light emitting diode.

In an embodiment, the light emitting device may further include at least one encapsulation layer configured to cover one surface of the substrate on which the first contact electrode and the second contact electrode are disposed.

In an embodiment, the light emitting diode may include a rod-type light emitting diode oriented in a horizontal direction between the first electrode and the second electrode.

According to an aspect of the present disclosure, a method of fabricating a light emitting device is provided in accordance with claim 11.

In an embodiment, the forming of the first contact electrode may include: forming a first contact portion by etching the first insulating layer such that one area of the first electrode is exposed; and forming the first contact electrode on at least the one area of the first electrode including the first contact portion and on the first end of the light emitting diode.

In an embodiment, the forming of the second contact electrode may include forming the second contact electrode on at least one area of the second electrode and the second end of the light emitting diode.

In an embodiment, the first contact electrode and the second contact electrode may be sequentially formed on the substrate, or the first contact electrode and the second contact electrode are simultaneously formed on the substrate.

In an embodiment, the method may include, after the forming of the second electrode, forming a third insulating layer configured to cover the second electrode. The light emitting diode may be supplied onto the substrate on which the third insulating layer is formed.

According to an aspect of the present disclosure, a display device is provided in accordance with claim 14.

### Advantageous Effects

In a light emitting device, a method of fabricating the light emitting device, and a display device including the light emitting device in accordance with embodiments of the present disclosure, a short-circuit defect between first and second electrodes may be prevented from occurring. Furthermore, light emitting diodes may be stably arranged between the first electrode and the second electrode.

### Description of Drawings

FIGS. 1A and 1B are respectively a perspective view and a sectional view illustrating a light emitting diode in accordance with an embodiment of the present disclosure.

FIGS. 2A and 2b are respectively a perspective view and a sectional view illustrating a light emitting diode in accordance with an embodiment of the present disclosure.

FIGS. 3A and 3B are respectively a perspective view and a sectional view illustrating a light emitting diode in accordance with an embodiment of the present disclosure.

FIG. 4 is a plan view illustrating a display device in accordance with an embodiment of the present disclosure.

FIGS. 5A to 5C each are a circuit diagram illustrating a light emitting device in accordance with an embodiment of the present disclosure, and for example illustrate different embodiments of an active pixel including the light emitting device.

FIG. 6 is a plan view illustrating a light emitting device in accordance with an embodiment of the present disclosure, for example, illustrating an example of a pixel formed of the light emitting device.

FIGS. 7A and 7B each are a sectional view illustrating a light emitting device in accordance with an embodiment of the present disclosure, and for example illustrate different embodiments of a cross-section corresponding to line I-I' of FIG. 6.

FIG. 8 is a plan view illustrating a light emitting device in accordance with an embodiment of the present disclosure, for example, illustrating an example of a pixel including the light emitting device.

FIGS. 9A and 9B each are a sectional view illustrating a light emitting device in accordance with an embodiment of the present disclosure, and for example illustrate different embodiments of a cross-section corresponding to line II-II' of FIG. 8.

FIGS. 10A to 10K are sectional views illustrating a method of fabricating a light emitting device in accordance with an embodiment of the present disclosure, and for example illustrate a method of fabricating the light emitting device in accordance with the embodiment of FIG. 9A.

FIG. 11 is a sectional view illustrating a light emitting device in accordance with an embodiment of the present disclosure and for example illustrates an embodiment of a cross-section corresponding to line II-II' of FIG. 8.

FIG. 12 is a sectional view illustrating a light emitting device in accordance with an embodiment of the present disclosure, and for example illustrates an embodiment of a cross-section corresponding to line II-II' of FIG. 8.

FIGS. 13A to 13I are sectional views illustrating a method of fabricating a light emitting device in accordance with an embodiment of the present disclosure, and for example illustrate a method of fabricating the light emitting device in accordance with the embodiment of FIG. 12.

FIG. 14 is a sectional view illustrating a light emitting device in accordance with an embodiment of the present disclosure, and for example illustrates an embodiment of a cross-section corresponding to line II-II' of FIG. 8.

FIGS. 15A to 15E are sectional views illustrating a method of fabricating a light emitting device in accordance with an embodiment of the present disclosure, and for example illustrate a method of fabricating the light emitting device in accordance with the embodiment of FIG. 14.

### Mode for Invention

Reference will now be made in detail to various embodiments of the present disclosure, specific examples of which are illustrated in the accompanying drawings and described below, and the embodiments of the present disclosure can be variously modified in many different forms. However, the present disclosure is not limited to the following embodiments and may be modified into various forms.

Some elements which are not directly related to the features of the present disclosure in the drawings may be omitted to clearly explain the present disclosure. Furthermore, the sizes, ratios, etc. of some elements in the drawings may be slightly exaggerated. It should be noted that the same reference numerals are used to designate the same or similar elements throughout the drawings, and repetitive explanations will be omitted.

It will be understood that, although the terms "first", "second", etc. may be used herein to describe various elements, these elements should not be limited by these terms. It will be further understood that the terms "comprise", "include", "have", etc. when used in this specification, specify the presence of stated features, integers, steps, operations, elements, components, and/or combinations of them but do not preclude the presence or addition of one or more other features, integers, steps, operations, elements, components, and/or combinations thereof. Furthermore, when a first component or part is disposed on a second component or part, the first component or part may be not only directly on the second component or part but a third component or part may intervene between them. Furthermore, the term "position", "direction", etc. used in the following description are defined in relative terms, and it should be noted that they may be changed into a reverse position or direction depending on a view angle or direction.

Embodiments and required details of the present disclosure are described with reference to the accompanying drawings in order to describe the present disclosure in detail so that those having ordinary knowledge in the technical field to which the present disclosure pertains can easily practice the present disclosure. Furthermore, a singular form may include a plural form as long as it is not specifically mentioned in a sentence.

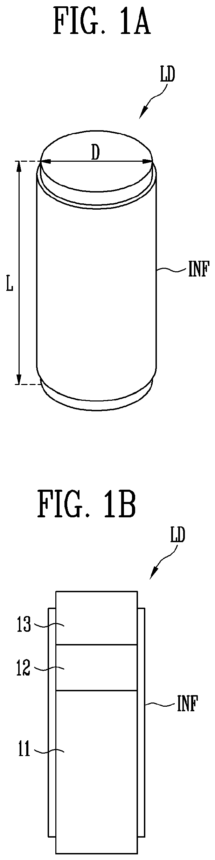

FIGS. 1A, 1B, 2A, 2B, 3A, and 3B are perspective diagrams and sectional diagrams illustrating light emitting diodes LD in accordance with embodiments of the present disclosure. Although FIGS. 1A to 3B illustrate cylindrical rod-type light emitting diodes LD, the type and/or shape of the light emitting diode LD in accordance with the present disclosure is not limited thereto.

Referring to FIGS. 1A and 1B, a light emitting diode LD in accordance with an embodiment of the present disclosure may include a first conductivity type semiconductor layer 11 (also referred to as a "first semiconductor layer"), a second conductivity type semiconductor layer 13 (also referred to as a "second semiconductor layer"), and an active layer 12 interposed between the first and second conductivity type semiconductor layers 11 and 13. For example, the light emitting diode LD may be configured of a stacked body formed by successively stacking the first conductivity type semiconductor layer 11, the active layer 12, and the second conductivity type semiconductor layer 13.

In an embodiment, the light emitting diode LD may be provided in the form of a rod extending in a direction. If the direction in which the light emitting diode LD extends is defined as a longitudinal direction, the light emitting diode LD may have a first end and a second end in the longitudinal direction.

In an embodiment, one of the first and second conductivity type semiconductor layers 11 and 13 may be disposed on the first end of the light emitting diode LD, and the other of the first and second conductivity type semiconductor layers 11 and 13 may be disposed on the second end of the light emitting diode LD.

In an embodiment, the light emitting diode LD may be a rod-type light emitting diode manufactured in the form of a rod. In this specification, the term "rod-type shape" embraces a rod-like shape and a bar-like shape such as a cylindrical shape and a prismatic shape extending in a longitudinal direction (i.e., having an aspect ratio greater than 1), and the cross-sectional shape thereof is not limited to a particular shape. For example, a length L of the light emitting diode LD may be greater than a diameter D thereof (or a width of the cross-section thereof).

In an embodiment, the light emitting diode LD may have a small size corresponding to a nanoscale size or a microscale size, e.g., a diameter D and/or a length L corresponding to a microscale to nanoscale range. However, in the present disclosure, the size of the light emitting diode LD is not limited thereto. For example, the size of the light emitting diode LD may be changed in various ways depending on design conditions of various devices, e.g., display devices, which employ, as a light source, a light emitting device using a light emitting diode LD.

The first conductivity type semiconductor layer 11 may include, for example, at least one n-type semiconductor layer. For instance, the first conductivity type semiconductor layer 11 may include an n-type semiconductor layer which includes any one semiconductor material of InAlGaN, GaN, AlGaN, InGaN, AlN, and InN, and is doped with a first conductive dopant such as Si, Ge, or Sn. However, the material for forming the first conductivity type semiconductor layer 11 is not limited thereto, and the first conductivity type semiconductor layer 11 may be formed of various other materials.

The active layer 12 may be disposed on the first conductivity type semiconductor layer 11 and have a single or multiple quantum well structure. In an embodiment, a cladding layer (not shown) doped with a conductive dopant may be formed on and/or under the active layer 12. For example, the cladding layer may be formed of an AlGaN layer or an InAlGaN layer. In an embodiment, a material such as AlGaN or AlInGaN may be used to form the active layer 12, and various other materials may be used to form the active layer 12.

If an electric field of a predetermined voltage or greater is applied to the opposite ends of the light emitting diode LD, the light emitting diode LD emits light by combination of electron-hole pairs in the active layer 12. Since light emission of the light emitting diode LD can be controlled based on the foregoing principle, the light emitting diode LD may be used as a light source of various light emitting devices as well as a pixel of a display device.

The second conductivity type semiconductor layer 13 may be disposed on the active layer 12 and include a semiconductor layer of a type different from that of the first conductivity type semiconductor layer 11. For example, the second conductivity type semiconductor layer 13 may include at least one p-type semiconductor layer. For instance, the second conductivity type semiconductor layer 13 may include a p-type semiconductor layer which includes any one semiconductor material of InAlGaN, GaN, AlGaN, InGaN, AlN, and InN, and is doped with a second conductive dopant such as Mg. However, the material forming the second conductivity type semiconductor layer 13 is not limited thereto, and the second conductivity type semiconductor layer 13 may be formed of various other materials.

In an embodiment, the light emitting diode LD may further include an insulating film INF provided on the surface of the light emitting diode LD. In an embodiment, the insulating film INF may be formed on the surface of the light emitting diode LD to enclose an outer circumferential surface of at least the active layer 12. In addition, the insulating film INF may further enclose an area of each of the first and second conductivity type semiconductor layers 11 and 13. Here, the insulating film INF may allow the opposite ends of the light emitting diode LD that have different polarities to be exposed to the outside. For example, the insulating film INF may expose one end of each of the first and second conductivity type semiconductor layers 11 and 13 that are disposed on the respective opposite ends of the light emitting diode LD in the longitudinal direction, e.g., may expose two base sides (the top and bottom surfaces) of the cylinder rather than covering the two base sides.

In an embodiment, the insulating film INF may include at least one insulating material of SiO₂, Si₃N₄, Al₂O₃, and TiO₂, but it is not limited thereto. In other words, the material that forms the insulating film INF is not limited to a particular material, and the insulating film INF may be formed of well-known various insulating materials.

In an embodiment, the light emitting diode LD may further include additional components in addition to the first conductivity type semiconductor layer 11, the active layer 12, the second conductivity type semiconductor layer 13, and/or the insulating film INF. For example, the light emitting diode LD may further include at least one fluorescent layer, at least one active layer, at least one semiconductor layer and/or at least one electrode layer disposed on one end of the first conductivity type semiconductor layer 11, the active layer 12, and/or the second conductivity type semiconductor layer 13.

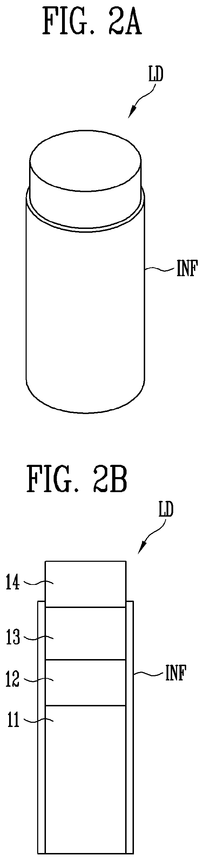

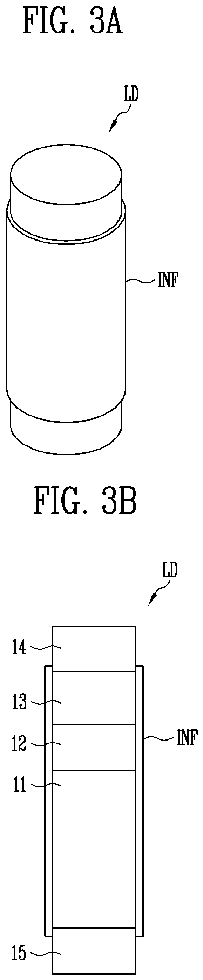

For example, as shown in FIGS. 2A and 2B, the light emitting diode LD may further include at least one electrode layer 14 disposed on one end of the second conductivity type semiconductor layer 13. In an embodiment, as shown in FIGS. 3A and 3B, the light emitting diode LD may further include at least one electrode layer 15 disposed on one end of the first conductivity type semiconductor layer 11.

Each of the electrode layers 14 and 15 may be an ohmic contact electrode, but it is not limited thereto. Furthermore, each of the electrode layers 14 and 15 may include metal or a metal oxide. For example, Cr, Ti, Al, Au, Ni, ITO, IZO, ITZO, and an oxide or alloy thereof may be used alone or in combination with each other. In an embodiment, the electrode layers 14 and 15 may be substantially transparent or translucent. Therefore, light generated from the light emitting diode LD may be emitted out of the light emitting diode LD after passing through the electrode layers 14 and 15.

In an embodiment, the insulating film INF may at least partially enclose or may not enclose the outer circumferential surfaces of the electrode layers 14 and 15. In other words, the insulating film INF may be selectively formed on the surfaces of the electrode layers 14 and 15. Furthermore, the insulating film INF may be formed to allow the opposite ends of the light emitting diode LD having different polarities to be exposed and, for example, may allow at least one area of each of the electrode layers 14 and 15 to be exposed. Alternatively, in an embodiment, the insulating film INF may not be provided.

If the insulating film INF is provided on the surface of the light emitting diode LD, particularly, on the surface of the active layer 12, the active layer 12 may be prevented from short-circuiting with at least one electrode (e.g., at least one contact electrode of contact electrodes connected to the opposite ends of the light emitting diode LD), which is not illustrated. Therefore, the electrical stability of the light emitting diode LD may be secured.

Furthermore, thanks to the insulating film INF formed on the surface of the light emitting diode LD, occurrence of a defect on the surface of the light emitting diode LD may be minimized, and thus the lifetime and efficiency of the light emitting diode LD may be improved. In addition, if the insulating film INF is formed on each light emitting diode LD, even in case that a plurality of light emitting diodes LD are disposed adjacent to each other, the light emitting diodes LD may be prevented from undesirably short-circuiting.

In an embodiment of the present disclosure, the light emitting diode LD may be fabricated through a surface treatment process. For example, the light emitting diode LD may be surface-treated (e.g., through a coating process) so that, in case that a plurality of light emitting diodes LD are mixed with a fluidic solution and then are supplied to each light emitting area (e.g., a light emitting area of each pixel), the light emitting diodes LD can be evenly distributed rather than unevenly aggregating in the solution.

The above-described light emitting diode LD may be used in various devices including a display device which requires a light source. For instance, at least one subminiature light emitting diode LD, e.g., a plurality of subminiature light emitting diodes LD each having a size ranging from the nanoscale to the microscale, may be disposed in each pixel area of a display panel so as to form a light source (or, a light source unit) of the corresponding pixel. Furthermore, the field of application of the light emitting diode LD according to the present disclosure is not limited to a display device. For example, the light emitting diode LD may also be used in various devices such as a lighting device, which requires a light source.

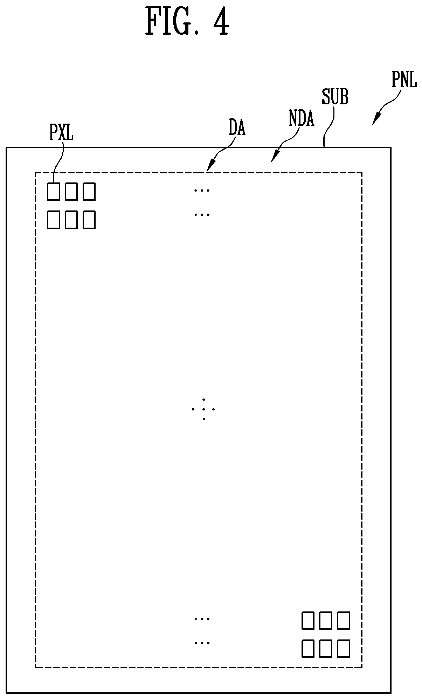

FIG. 4 is a plan view illustrating a display device in accordance with an embodiment of the present disclosure. In an embodiment, FIG. 4 illustrates a display device, particularly, a display panel PNL provided in the display device, as an example of a device in which the light emitting diode LD described with reference to FIGS. 1A to 3B may be used as a light source. For example, pixels PXL of the display panel PNL each may include a light emitting device. The light emitting device may include at least one light emitting diode LD.

For the sake of explanation, FIG. 4 simply illustrates a structure of the display panel PNL in accordance with an embodiment, focusing on a display area DA. In some embodiments, although not illustrated, at least one driving circuit (e.g., at least one of a scan driver and a data driver) and/or a plurality of lines may be further provided on the display panel PNL.

Referring to FIG. 4, the display panel PNL in accordance with an embodiment of the present disclosure may include a substrate SUB, and a plurality of pixels PXL disposed on the substrate SUB. In detail, the display panel PNL and the substrate SUB for forming the display panel PNL may include a display area DA for displaying an image, and a non-display area NDA formed in a predetermined area other than the display area DA. The pixels PXL may be disposed in the display area DA on the substrate SUB.

In an embodiment, the display area DA may be disposed in a central area of the display panel PNL, and the non-display area NDA may be disposed in a perimeter area of the display panel PNL in such a way as to enclose the display area DA. The locations of the display area DA and the non-display area NDA are not limited thereto, and the locations thereof may be changed.

The substrate SUB may form a base of the display panel PNL. In an embodiment, the substrate SUB may be a rigid or flexible substrate, and the material or properties thereof are not particularly limited. For example, the substrate SUB may be a rigid substrate made of glass or reinforced glass, or a flexible substrate formed of a thin film made of plastic or metal. Furthermore, the substrate SUB may be a transparent substrate, but it is not limited thereto. For instance, the substrate SUB may be a translucent substrate, an opaque substrate, or a reflective substrate.

An area on the substrate SUB is defined as the display area DA on which the pixels PXL are disposed, and the other area thereof is defined as the non-display area NDA. For example, the substrate SUB may include the display area DA including a plurality of pixel areas in which the respective pixels PXL are formed, and the non-display area NDA disposed around the display area DA. Various lines and/or internal circuits which are connected to the pixels PXL of the display area DA may be disposed in the non-display area NDA.

In an embodiment, the pixels PXL may be distributed and arranged in the display area DA. In an embodiment, the pixels PXL may be arranged in a stripe shape in the display area DA. However, the present disclosure is not limited thereto. For example, the pixels PXL may be arranged in various well-known shapes in the display area DA.

Each pixel PXL may include at least one light source, which is driven by a predetermined control signal (e.g., a scan signal and a data signal) and/or power (e.g., first and second power) and may include, for example, a light emitting diode LD according to any one of the embodiments of FIGS. 1A to 3B. For example, each pixel PXL may include at least one light emitting diode LD having a small size ranging from the nanoscale to the microscale. For example, each pixel PXL may include a plurality of rod-type light emitting diodes which are connected in parallel between pixel electrodes and/or power lines. The plurality of rod-type light emitting diodes may form a light emitting device of each pixel PXL (e.g., a light source or a light source unit of each pixel PXL).

In an embodiment, each pixel PXL may be formed of an active pixel. However, the types, structures, and/or driving schemes of the pixels PXL capable of being applied to the display device according to the present disclosure are not particularly limited. For example, each pixel PXL may have the same structure as that of a pixel of various well-known passive or active light emitting display devices.

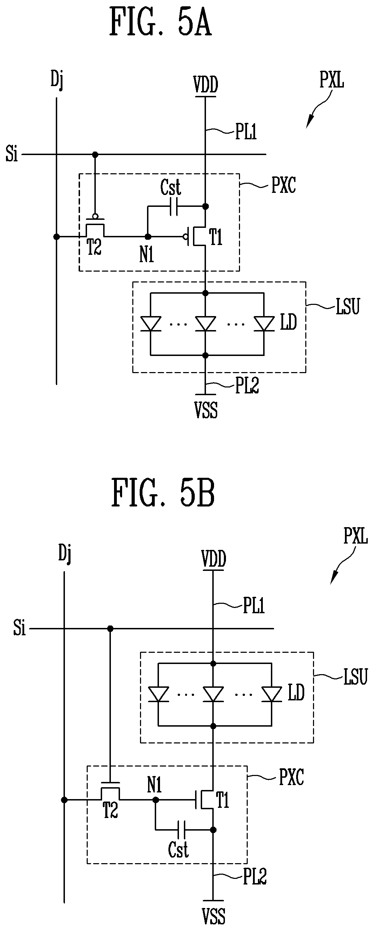

FIGS. 5A to 5C each are a circuit diagram illustrating a light emitting device in accordance with an embodiment of the present disclosure, and for example illustrate different embodiments of an active pixel PXL including the light emitting device. In an embodiment, each pixel PXL illustrated in FIGS. 5A to 5C may be any one of the pixels PXL provided on the display panel PNL of FIG. 4. The pixels PXL may have substantially the same or similar structure.

Referring to FIG. 5A, the pixel PXL in accordance with an embodiment of the present disclosure may include a light source unit LSU configured to generate light having a luminance corresponding to a data signal, and a pixel circuit PXC configured to drive the light source unit LSU. The light source unit LSU may form a light emitting device in accordance with an embodiment of the present disclosure.

In an embodiment, the light source unit LSU may include a plurality of light emitting diodes LD connected in parallel to each other between a first power supply VDD and a second power supply VSS. Here, the first and second power supplies VDD and VSS may have different potentials so that the light emitting diodes LD may emit light. For example, the first power supply VDD may be set as a high-potential power supply, and the second power supply VSS may be set as a low-potential power supply. Here, a difference in potential between the first and second power supplies VDD and VSS may be set to a voltage equal to or greater than a threshold voltage of the light emitting diodes LD during at least a light emitting period of the pixel PXL.

Although FIG. 5A illustrates an embodiment in which the light emitting diodes LD forming the light source unit LSU of each pixel PXL are connected in parallel to each other in the same direction (e.g., a forward direction) between the first power supply VDD and the second power supply VSS, the present disclosure is not limited thereto. For example, in an embodiment, some of the light emitting diodes LD may be connected to each other in a first direction (e.g., the forward direction) between the first and second power supplies VDD and VSS, and the other light emitting diodes LD may be connected to each other in a second direction (e.g., a reverse direction). Alternatively, in an embodiment, at least one pixel PXL may include only a single light emitting diode LD.

In an embodiment, first ends of the light emitting diodes LD forming each light source unit LSU may be connected in common to a corresponding pixel circuit PXC through a first electrode of the light source unit LSU, and may be connected to the first power supply VDD through the pixel circuit PXC and a first power line PL1. Second ends of the light emitting diodes LD may be connected in common to the second power supply VSS through a second electrode of the light source unit LSU and a second power line PL2.

Each light source unit LSU may emit light having a luminance corresponding to driving current supplied thereto through the corresponding pixel circuit PXC. Therefore, a predetermined image may be displayed in the display area DA.

The pixel circuit PXC may be connected to a scan line Si and a data line Dj of the corresponding pixel PXL. For example, if the pixel PXL is disposed in an i-th row (where i is a natural number) and a j-th column (where j is a natural number) of the display area DA, the pixel circuit PXC of the pixel PXL may be connected to an i-th scan line Si and a j-th data line Dj of the display area DA. The pixel circuit PXC may include first and second transistors T1 and T2, and a storage capacitor Cst.

The first transistor T1 (driving transistor) is connected between the first power supply VDD and the first electrode of the light source unit LSU. A gate electrode of the first transistor T1 is connected to a first node N1. The first transistor T1 may control driving current to be supplied to the light source unit LSU in response to a voltage of the first node N1.

The second transistor T2 (switching transistor) may be connected between the data line Dj and the first node N1. A gate electrode of the second transistor T2 is connected to the scan line Si.

When a scan signal of a gate-on voltage (e.g., a low voltage) is supplied from the scan line Si, the second transistor T2 is turned on to electrically connect the first node N1 to the data line Dj. During each frame period, a data signal of a corresponding frame is supplied to the data line Dj. The data signal is transmitted to the first node N1 via the second transistor T2. Therefore, a voltage corresponding to the data signal is charged to the storage capacitor Cst.

One electrode of the storage capacitor Cst is connected to the first power supply VDD, and the other electrode thereof is connected to the first node N1. The storage capacitor Cst may store a voltage corresponding to a data signal supplied to the first node N1 during each frame period and may maintain the stored voltage until a data signal of a subsequent frame is supplied thereto.

Although in FIG. 5A the transistors, e.g., the first and second transistors T1 and T2, included in the pixel circuit PXC have been illustrated as being formed of P-type transistors, the present disclosure is not limited thereto. In other words, any one of the first and second transistors T1 and T2 may be changed to an N-type transistor.

For example, as shown in FIG. 5B, both the first and second transistors T1 and T2 may be formed of N-type transistors. The configuration and operation of the pixel PXL illustrated in FIG. 5B are substantially similar to those of the pixel PXL of FIG. 5A, except that connection positions of some circuit elements are changed as well as changes in types of the transistors. Therefore, detailed descriptions of the pixel PXL of FIG. 5B will be omitted.

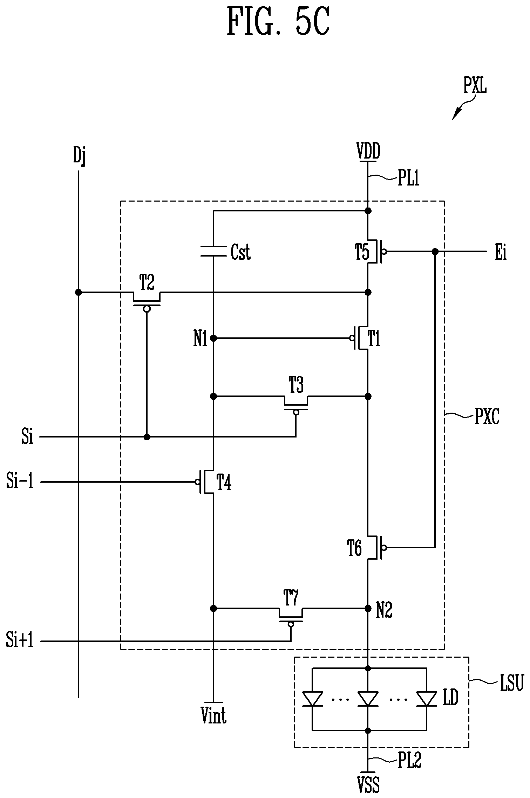

The structure of the pixel circuit PXC is not limited to the embodiments shown in FIGS. 5A and 5B. In other words, the pixel circuit PXC may be formed of a well-known pixel circuit which may have various structures and/or be operated by various driving schemes. For example, the pixel circuit PXC may be configured in the same manner as that of an embodiment illustrated in FIG. 5C.

Referring to FIG. 5C, the pixel circuit PXC may be connected not only to a scan line Si of a corresponding horizontal line but also to at least one other scan line (or a control line). For example, the pixel circuit PXC of the pixel PXL disposed in the i-th row of the display area DA may be further connected to an i-1-th scan line Si-1 and/or an i+1-th scan line Si+1. In an embodiment, the pixel circuit PXC may be connected not only to the first and second power supplies VDD and VSS but also to other power supplies. For instance, the pixel circuit PXC may also be connected to an initialization power supply Vint. In an embodiment, the pixel circuit PXC may include first to seventh transistors T1 to T7 and a storage capacitor Cst.

The first transistor T1 is connected between the first power supply VDD and the first electrode of the light source unit LSU. A gate electrode of the first transistor T1 is connected to a first node N1. The first transistor T1 may control driving current to be supplied to the light source unit LSU in response to a voltage of the first node N1.

The second transistor T2 is connected between the data line Dj and one electrode of the first transistor T1. A gate electrode of the second transistor T2 is connected to the corresponding scan line Si. When a scan signal of a gate-on voltage is supplied from the scan line Si, the second transistor T2 may be turned on to electrically connect the data line Dj to the one electrode of the first transistor T1. Therefore, if the second transistor T2 is turned on, a data signal supplied from the data line Dj may be transmitted to the first transistor T1.

The third transistor T3 is connected between the other electrode of the first transistor T1 and the first node N1. A gate electrode of the third transistor T3 is connected to the corresponding scan line Si. When a scan signal of a gate-on voltage is supplied from the scan line Si, the third transistor T3 may be turned on to electrically connect the first transistor T1 in the form of a diode.

The fourth transistor T4 may be connected between the first node N1 and an initialization power supply Vint. A gate electrode of the fourth transistor T4 is connected to a preceding scan line, e.g., an i-1-th scan line Si-1. When a scan signal of a gate-on voltage is supplied to the i-1-th scan line Si-1, the fourth transistor T4 may be turned on so that the voltage of the initialization power supply Vint may be transmitted to the first node N1. Here, the voltage of the initialization power supply Vint may be a minimum voltage of a data signal or less.

The fifth transistor T5 is connected between the first power supply VDD and the first transistor T1. A gate electrode of the fifth transistor T5 is connected to a corresponding emission control line, e.g., an i-th emission control line Ei. The fifth transistor T5 may be turned off when an emission control signal of a gate-off voltage (e.g., a high voltage) is supplied to the emission control line Ei, and may be turned on in other cases.

The sixth transistor T6 is connected between the first transistor T1 and a second node N2, which is electrically connected to the first electrode of the light source unit LSU. A gate electrode of the sixth transistor T6 is connected to a corresponding emission control line, e.g., the i-th emission control line Ei. The sixth transistor T6 may be turned off when an emission control signal of a gate-off voltage is supplied to the emission control line Ei, and may be turned on in other cases.

The seventh transistor T7 is connected between the second node N2, which is electrically connected to the first electrode of the light source unit LSU, and the initialization power supply Vint. A gate electrode of the seventh transistor T7 is connected to any one of scan lines of a subsequent stage, e.g., to the i+1-th scan line Si+1. When a scan signal of a gate-on voltage is supplied to the i+1-th scan line Si+1, the seventh transistor T7 may be turned on so that the voltage of the initialization power supply Vint may be supplied to the first electrode of the light source unit LSU.

The storage capacitor Cst is connected between the first power supply VDD and the first node N1. The storage capacitor Cst may store a voltage corresponding both to the data signal applied to the first node N1 during each frame period and to the threshold voltage of the first transistor T1.

Although in FIG. 5C illustrates the transistors, e.g., the first to seventh transistors T1 to T7, included in the pixel circuit PXC have been illustrated as being formed of P-type transistors, the present disclosure is not limited thereto. For example, at least one of the first to seventh transistors T1 to T7 may be changed to an N-type transistor.

The structure of the pixel PXL which may be applied to the present disclosure is not limited to the embodiments illustrated in FIGS. 5A through 5C, and each pixel PXL may have various well-known structures. For example, the pixel circuit PXC included in each pixel PXL may be formed of a well-known pixel circuit which may have various structures and/or be operated by various driving schemes. In an embodiment of the present disclosure, each pixel PXL may be configured in a passive light emitting display device, or the like. In this case, the pixel circuit PXC may be omitted, and each of the first and second electrodes of the light source unit LSU may be directly connected to the scan line Si, the data line Dj, a power line, and/or the control line.

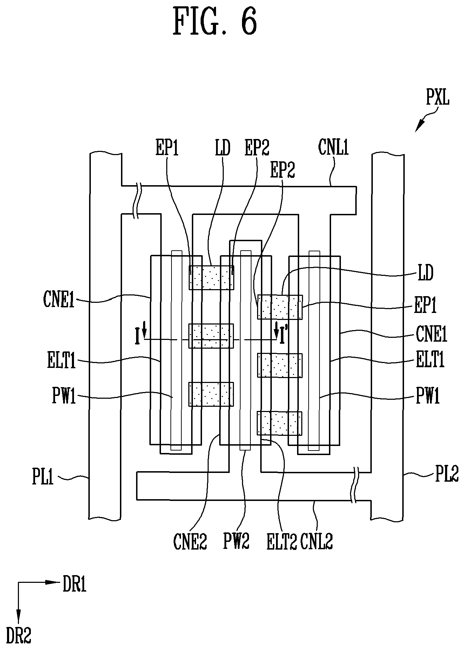

FIG. 6 is a plan view illustrating a light emitting device in accordance with an embodiment of the present disclosure and, for example, illustrates an example of a pixel PXL including the light emitting device. In an embodiment, FIG. 6 illustrates a light emitting device (e.g., a pixel PXL of a passive light emitting display device) which includes first and second power lines PL1 and PL2 (or signal lines such as scan lines and data lines) or is directly connected to the first and second power lines PL1 and PL2. However, the light emitting device according to the present disclosure is not limited to the embodiment illustrated in FIG. 6. For example, in an embodiment of the present disclosure, the light emitting device may be connected to the first and/or second power line PL1 and/or PL2 via at least one circuit element (e.g., the pixel circuit PXC of FIGS. 5A to 5C), a connection line, a signal line, or the like.

Referring to FIG. 6, the pixel PXL in accordance with an embodiment of the present disclosure includes a first electrode ELT1 and a second electrode ELT2 which are spaced apart from each other, at least one light emitting diode LD disposed between the first and second electrodes ELT1 and ELT2, e.g., a plurality of light emitting diodes LD arranged in parallel to each other, and first and second contact electrodes CNE1 and CNE2 which electrically connect (or couple) the light emitting diodes LD between the first and second electrodes ELT1 and ELT2. The pixel PXL may further include a first connection electrode CNL1 which connects the first electrode ELT1 to the first power line PL1, and a second connection electrode CNL2 which connects the second electrode ELT2 to the second power line PL2. In an embodiment, the first and second connection electrodes CNL1 and CNL2 may be respectively and integrally connected to the first and second electrodes ELT1 and ELT2, or electrically connected (or coupled) to the first and second electrodes ELT1 and ELT2 via at least one contact hole or the like. In case that the first and second connection electrodes CNL1 and CNL2 are respectively and integrally connected to the first and second electrodes ELT1 and ELT2, each of the first and second connection electrodes CNL1 and CNL2 may be regarded as an area of a corresponding electrode of the first and second electrodes ELT1 and ELT2. The pixel PXL further includes a first partition wall PW1 (also referred to as a "first wall", "first bank" or "first pattern") which overlaps the first electrode ELT1 and a second partition wall PW2 (also referred to as a "second wall", "second bank" or "second pattern") which overlaps the second electrode ELT2.

The first and second partition walls PW1 and PW2, the first and second electrodes ELT1 and ELT2, the light emitting diodes LD, and the first and second contact electrodes CNE1 and CNE2 form a light emitting device in accordance with an embodiment of the present disclosure. The first and second partition walls PW1 and PW2, the first and second electrodes ELT1 and ELT2, the light emitting diodes LD, and the first and second contact electrodes CNE1 and CNE2 form a light source unit (e.g., the LSU of FIGS. 5A to 5C) of the pixel PXL in accordance with an embodiment of the present disclosure.

The first electrode ELT1 and the second electrode ELT2 are spaced apart from each other and disposed such that at least portions thereof face each other. For example, the first and second electrodes ELT1 and ELT2 may be disposed in parallel to each other at positions spaced apart from each other by a predetermined distance on one surface of a substrate provided to form the base of the pixel PXL (or the light emitting device). For example, in a predetermined emission area, the first and second electrodes ELT1 and ELT2 may be spaced apart from each other by a predetermined distance in the first direction DR1, and each may extend in the second direction DR2 intersecting with the first direction DR1. However, the present disclosure is not limited thereto. For example, the shapes and/or the mutual disposition relationship of the first and second electrodes ELT1 and ELT2 may be changed in various ways, within the constraints indicated by appended claim 1.

In an embodiment, each of the first and second electrodes ELT1 and ELT2 may have a single-layer or multi-layer structure. For example, each first electrode ELT1 may have a multi-layer structure including a first reflective electrode and a first conductive capping layer. Each second electrode ELT2 may have a multi-layer structure including a second reflective electrode and a second conductive capping layer.

In an embodiment, the first electrode ELT1 may be connected to the first power line PL1 through the first connection electrode CNL1. In an embodiment, the first electrode ELT1 and the first connection electrode CNL1 may extend in different directions. For example, in case that the first connection electrode CNL1 extends in the first direction DR1 (e.g., in a horizontal direction), the first electrode ELT1 may extend in the second direction DR2 (e.g., in a vertical direction) intersecting the first direction DR1.

In an embodiment, the first electrode ELT1 may be integrally connected with the first connection electrode CNL1. For instance, the first electrode ELT1 may diverge in at least one way from the first connection electrode CNL1. However, the present disclosure is not limited thereto. For example, in an embodiment, the first electrode ELT1 and the first connection electrode CNL1 may be individually formed and electrically connected to each other through at least one contact hole, at least one via hole, or the like.

In an embodiment, the first electrode ELT1 and/or the first connection electrode CNL1 may be integrally connected with the first power line PL1. In an embodiment, the first electrode ELT1 and/or the first connection electrode CNL1 may be formed separately from the first power line PL1 and electrically connected to the first power line PL1 via at least one contact hole and/or at least one circuit element. Therefore, first power to be supplied to the first power line PL1 may be transmitted to the first electrode ELT1.

In an embodiment, the second electrode ELT2 may be connected to the second power line PL2 through the second connection electrode CNL2. In an embodiment, the second electrode ELT2 and the second connection electrode CNL2 may extend in different directions. For example, in case that the second connection electrode CNL2 extends in the first direction DR1, the second electrode ELT2 may extend in the second direction DR2 intersecting the first direction DR1.

In an embodiment, the second electrode ELT2 may be integrally connected with the second connection electrode CNL2. For instance, the second electrode ELT2 may diverge in at least one way from the second connection electrode CNL2. However, the present disclosure is not limited thereto. For example, in an embodiment, the second electrode ELT2 and the second connection electrode CNL2 may be separately formed and electrically connected to each other through at least one contact hole, at least one via hole, or the like.

In an embodiment, the second electrode ELT2 and/or the second connection electrode CNL2 may be integrally connected with the second power line PL2. In an embodiment, the second electrode ELT2 and/or the second connection electrode CNL2 may be formed individually from the second power line PL2 and electrically connected to the second power line PL2 via at least one contact hole and/or at least one circuit element. Therefore, second power to be supplied to the second power line PL2 may be transmitted to the second electrode ELT2.

In an embodiment, the first power supply (e.g., VDD of FIGS. 5A to 5C) and the second power supply (e.g., VSS of FIGS. 5A to 5C) may have different potentials. For example, a difference in potential between the first power supply VDD and the second power supply VSS may be equal to or greater than a threshold voltage of the light emitting diodes LD. In an embodiment, the first power supply VDD and the second power supply VSS may have potentials enabling at least one light emitting diode LD to be connected between the first and second electrodes ELT1 and ELT2 in a forward direction. In other words, the voltage between the first power supply VDD and the second power supply VSS may have a value enabling at least one light emitting diode LD included in the pixel PXL (or the light emitting device) to emit light.

According to the invention, the first partition wall PW1 is disposed under the first electrode ELT1 such that the first partition wall PW1 overlaps an area of the first electrode ELT1. The second partition wall PW2 is disposed under the second electrode ELT2 such that the second partition wall PW2 overlaps an area of the second electrode ELT2. The first and second partition walls PW1 and PW2 are disposed in a predetermined emission area at positions spaced apart from each other and respectively make areas of the first and second electrode ELT1 and ELT2 protrude upward. The first electrode ELT1 is disposed on the first partition wall PW1 and protrude in a height direction by the first partition wall PW1. The second electrode ELT2 is disposed on the second partition wall PW2 and protrude in the height direction by the second partition wall PW2.

In an embodiment, the light emitting diodes LD may be connected in parallel with each other between the first electrode ELT1 and the second electrode ELT2. For example, each light emitting diode LD may be a rod-type light emitting diode which is arranged between the first and second electrodes ELT1 and ELT2 in the first direction DR1, e.g., in the horizontal direction, in an area in which the first electrode ELT1 and the second electrode ELT2 are disposed to face each other.

Although FIG. 6 illustrates that the light emitting diodes LD are uniformly arranged in any one direction, e.g., the first direction DR1, the present disclosure is not limited thereto. For example, at least one of the light emitting diodes LD may be arranged between the first and second electrodes ELT1 and ELT2 in a diagonal direction.

In an embodiment, each light emitting diode LD may be a light emitting diode which is made of material having an inorganic crystal structure and has a subminiature size, e.g., ranging from the nanoscale to the microscale. For example, each light emitting diode LD may be a subminiature rod-type light emitting diode which has a diameter D and/or a length L ranging from the nanoscale to the microscale, as illustrated in FIGS. 1A to 3B. However, the size of the light emitting diode LD may be changed in various ways depending on design conditions or the like of each light emitting device, e.g., the pixel PXL.

The first ends EP1 of the light emitting diodes LD are electrically connected to the first electrode ELT1 via the first contact electrode CNE1. The second ends EP2 of the light emitting diodes LD are electrically connected to the second electrode ELT2 via the second contact electrode CNE2. In an embodiment, at least one of the first and second ends EP1 and EP2 of each light emitting diode LD may directly contact the first and/or second electrodes ELT1 and/or ELT2 and be electrically connected to the first and/or second electrodes ELT1 and/or ELT2.

In an embodiment, the light emitting diodes LD may be prepared in a diffused form in a predetermined solution, and then supplied by an inkjet printing scheme or the like to a predetermined emission area (e.g., the emission area of each pixel PXL) defined in the light emitting device. For example, the light emitting diodes LD may be mixed with a volatile solvent and supplied to each emission area. Here, if the voltage of the first power supply VDD and the second power supply VSS are respectively applied to the first and second electrodes ELT1 and ELT2 through the first and second power lines PL1 and PL2, an electric field is formed between the first and second electrodes ELT1 and ELT2, whereby the light emitting diodes LD are aligned between the first and second electrodes ELT1 and ELT2. After the light emitting diodes LD have been aligned, the solvent may be removed by a volatilization method or other methods. In this way, the light emitting diodes LD may be reliably arranged between the first and second electrodes ELT1 and ELT2. Furthermore, the first contact electrode CNE1 and the second contact electrode CNE2 are respectively formed on the opposite ends, i.e., the first and second ends EP1 and EP2, of the light emitting diodes LD. Therefore, the light emitting diodes LD may be more reliably connected between the first and second electrodes ELT1 and ELT2.

According to the invention, the first contact electrode CNE1 is formed to cover both the first ends EP1 of the light emitting diodes LD and at least one area of the first electrode ELT1, whereby the first ends EP1 of the light emitting diodes LD are physically and electrically connected to the first electrode ELT1. Likewise, the second contact electrode CNE2 is formed to cover both the second ends EP2 of the light emitting diodes LD and at least one area of the second electrode ELT2, whereby the second ends EP2 of the light emitting diodes LD are physically and electrically connected to the second electrode ELT2.

When the voltage of the first power supply VDD (or, a predetermined first control signal such as a scan signal or a data signal) is applied to the first ends EP1 of the light emitting diodes LD via the first power line PL1 and the first electrode ELT1, and the voltage of the second power supply VSS (or a predetermined second control signal such as a scan signal or a data signal) is applied to the second ends EP2 of the light emitting diodes LD via the second power line PL2 and the second electrode ELT2, at least one light emitting diode LD that is connected between the first and second electrodes ELT1 and ELT2 in the forward direction may emit light. Therefore, the pixel PXL may emit light.

According to the invention, the first electrode ELT1 and the second electrode ELT2 are disposed on different layers of the substrate that are separated from each other with at least one insulating layer interposed therebetween. As such, if the first electrode ELT1 and the second electrode ELT2 are separately disposed on different layers, a short-circuit defect between the first electrode ELT1 and the second electrode ELT2 may be effectively prevented from occurring during a process of fabricating the pixel PXL. Detailed description of a stacked structure of the light emitting device including the first electrode ELT1 and the second electrode ELT2 will be made below.

According to the invention, the first electrode ELT1 and the second electrode ELT2 are spaced apart from each other by a predetermined distance not to overlap each other in a plan view (i.e., when viewed form top). For example, the first electrode ELT1 and the second electrode ELT2 may be disposed in a predetermined emission area at positions spaced apart from each other by a predetermined distance in the first direction DR1. In an embodiment, the interval and/or distance between the first electrode ELT1 and the second electrode ELT2 may remain constant, or be changed by sections or areas. The light emitting diodes LD may be easily disposed in a desired area by adjusting the positions and/or intervals of the first and second electrodes ELT1 and ELT2.

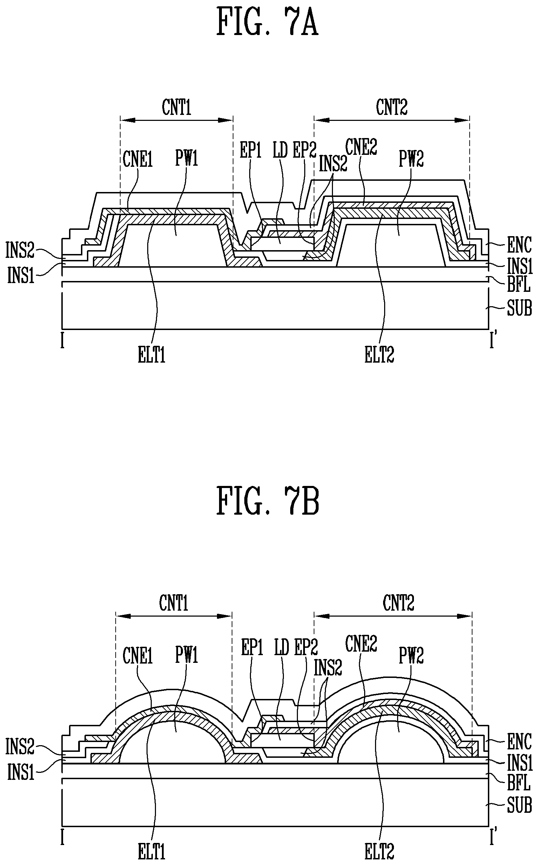

FIGS. 7A and 7B each are a sectional view illustrating a light emitting device in accordance with an embodiment of the present disclosure, and for example illustrate different embodiments of a cross-section corresponding to line I-I' of FIG. 6. In embodiments, the light emitting device of each of FIGS. 7A and 7B may correspond to a passive pixel PXL, and FIGS. 7A and 7B illustrate different embodiments with regard to the shapes of first and second partition walls PW1 and PW2. However, the light emitting device in accordance with the present disclosure is not limited to the pixel PXL.

Referring to FIGS. 6, 7A, and 7B, the pixel PXL (or the light emitting device) in accordance with an embodiment of the present disclosure includes a substrate SUB, and a buffer layer BFL, first and second partition walls PW1 and PW2, a first electrode ELT1, a first insulating layer INS1, a second electrode ELT2, at least one light emitting diode LD (e.g., a plurality of light emitting diodes LD), a second contact electrode CNE2, a second insulating layer INS2, a first contact electrode CNE1, and an encapsulation layer ENC which are successively disposed on one surface of the substrate SUB. For example, in an embodiment of the present disclosure, based on the one surface of the substrate SUB, the buffer layer BFL may be disposed on a first layer, the first and second partition walls PW1 and PW2 may be disposed on a second layer, the first electrode ELT1 may be provided on a third layer, the first insulating layer INS1 may be disposed on a fourth layer, the second electrode ELT2 may be disposed on a fifth layer, the light emitting diode LD may be disposed on a sixth layer, the second contact electrode CNE2 may be disposed on a seventh layer, the second insulating layer INS2 may be disposed on an eighth layer, the first contact electrode CNE1 may be disposed on a ninth layer, and the encapsulation layer ENC may be disposed on a tenth layer. Here, the above-defined respective positions of the components on the layers may be based on mutual arrangement relationship between the components disposed on the substrate SUB and/or a sequence of forming the components, and may not be based on distances, heights, or the like from the substrate SUB. Furthermore, in some comparative examples not forming part of the invention as claimed, at least one of the foregoing components may be omitted, or the position thereof may be changed. For example, the positions of the first electrode ELT1 and the second electrode ELT2 on the layers may be switched with each other. Likewise, the positions of the first contact electrode CNE1 and the second contact electrode CNE2 on the layers may be switched with each other. Furthermore, in an in a comparative example not forming part of the invention as claimed, at least one of the components illustrated in FIGS. 7A and 7B may be selectively omitted, or other additional components may be provided in each pixel PXL.

The substrate SUB may form a base of the display panel (e.g., the PNL of FIG. 4) including the pixel PXL and may be a rigid substrate or a flexible substrate. Furthermore, the substrate SUB may be a transparent substrate but is not limited thereto. In other words, in the present disclosure, the material or property of the substrate SUB is not particularly limited. The buffer layer BFL may be disposed on the one surface of the substrate SUB.

The buffer layer BFL may prevent impurities from diffusing into electrodes, lines, and/or a circuit element that are disposed on the buffer layer BFL. In an embodiment, the buffer layer BFL may be formed of a single layer, or may be formed of multiple layers having two or more layers. In the case where the buffer layer BFL has a multilayer structure, the respective layers may be formed of the same material or different materials. In an embodiment, the buffer layer BFL may be omitted. The buffer layer BFL may be selectively formed on the one surface of the substrate SUB. The first partition wall PW1 and the second partition wall PW2 may be disposed on the one surface of the substrate SUB on which the buffer layer BFL is formed.

The first partition wall PW1 and the second partition wall PW2 are disposed on the one surface of the substrate SUB at positions spaced apart from each other. For example, the first and second partition walls PW1 and PW2 may be disposed on the same layer on the substrate SUB at positions spaced apart from each other by a predetermined distance. However, the present disclosure is not limited thereto, and the positions of the first and second partition walls PW1 and PW2 on the layers may be changed.

According to the invention, the first partition wall PW1 is disposed between the substrate SUB and one area of the first electrode ELT1. The second partition wall PW2 is disposed between the substrate SUB and one area of the second electrode ELT2. In an embodiment, the first and second partition walls PW1 and PW2 may have substantially the same structure, shape, and/or height, but the present disclosure is not limited thereto.

Each of the first and second partition walls PW1 and PW2 may have various shapes. For example, as illustrated in FIG. 7A, each of the first and second partition walls PW1 and PW2 may have a cross-sectional shape of a trapezoid, the width of which reduces from the bottom to the top thereof. In this case, each of the first and second partition walls PW1 and PW2 may have an inclined surface on at least one side thereof. In an embodiment, as illustrated in FIG. 7B, each of the first and second partition walls PW1 and PW2 may have a semi-circular or semi-elliptical cross-section the width of which is gradually reduced upward. In this case, each of the first and second partition walls PW1 and PW2 may have a curved surface on at least one side thereof. In other words, the shape of each of the first and second partition walls PW1 and PW2 may be changed in various ways rather than being particularly limited. In an embodiment, at least one of the first and second partition walls PW1 and PW2 may be changed in position.

In an embodiment, each of the first and second partition walls PW1 and PW2 may include insulating material having an inorganic material or an organic material. Furthermore, each of the first and second partition walls PW1 and PW2 may have a single-layer structure or a multi-layer structure. In other words, the material and/or the stacked structure of each of the first and second partition walls PW1 and PW2 may be changed in various ways rather than being particularly limited.

In an embodiment of the present disclosure, each of the first and second partition walls PW1 and PW2 may also function as a reflective member. For example, the first and second partition walls PW1 and PW2, along with the first and second electrodes ELT1 and ELT2 provided on the first and second partition walls PW1 and PW2, may function as reflective members for enhancing the efficiency of light emitted from each light emitting diode LD.

The first electrode ELT1 and the first contact electrode CNE1 are disposed over the first partition wall PW1. The second electrode ELT2 and the second contact electrode CNE2 are disposed over the second partition wall PW2. In an embodiment of the present disclosure, at least one insulating layer may be interposed between the first partition wall PW1 and the first electrode ELT1 and/or between the second partition wall PW2 and the second electrode ELT2. For example, the first insulating layer INS1 may be interposed between the second partition wall PW2 and the second electrode ELT2. In an embodiment, at least one electrode and/or insulating layer disposed over each of the first and second partition walls PW1 and PW2 may have a shape corresponding to the shape of the corresponding one of the first and second partition walls PW1 and PW2.

In detail, the first electrode ELT1 is disposed on the one surface of the substrate SUB on which the first and second partition walls PW1 and PW2 are formed. In an embodiment, the first electrode ELT1 may be any one pixel electrode, e.g., one of an anode electrode and a cathode electrode.

According to the invention, the first electrode ELT1 is disposed on at least one area of the first partition wall PW1. For example, the first electrode ELT1 may be disposed on the first partition wall PW1 to completely cover the first partition wall PW1.

The first electrode ELT1 may have a shape corresponding to that of the first partition wall PW1. For example, the first electrode ELT1 may have an inclined surface or a curved surface corresponding to the shape of the first partition wall PW1. In a comparative example not forming part of the invention as claimed, the first partition wall PW1 may not be provided in the pixel PXL. In this case, the first electrode ELT1 may have a substantially planar shape.

In an embodiment, the first electrode ELT1 may include various conductive materials. For example, the first electrode ELT1 may have at least one reflective electrode layer, but the present disclosure is not limited thereto.

For instance, the first electrode ELT1 may include conductive material having a predetermined reflectivity. For example, the first electrode ELT1 may include at least one of a metal such as Ag, Mg, Al, Pt, Pd, Au, Ni, Nd, Ir, Cr, or an alloy thereof, a conductive oxide such as indium tin oxide (ITO), indium zinc oxide (IZO), zinc oxide (ZnO), or indium tin zinc oxide (ITZO), and a conductive polymer such as PEDOT, but the present disclosure is not limited thereto. In other words, the material for forming the first electrode ELT1 is not particularly limited, and the first electrode ELT1 may include various well-known electrode materials.

Furthermore, the first electrode ELT1 may be configured of a single layer or multiple layers, and the stacked structure thereof is not limited thereto. For example, the first electrode ELT1 may have a multi-layer structure including at least one reflective electrode layer and at least one conductive capping layer. Furthermore, the first electrode ELT1 may selectively further include at least one transparent electrode layer.

For example, the first electrode ELT1 may include at least one reflective electrode layer, at least one transparent electrode layer disposed over and/or under the reflective electrode layer, and at least one conductive capping layer configured to cover an upper portion of the reflective electrode layer and/or the transparent electrode layer. In an embodiment, the reflective electrode layer may be formed of various conductive materials, e.g., Ag, having reflectivity, and the constituent material thereof is not particularly limited. In the case where the first electrode ELT1 includes a reflective electrode layer, the first electrode ELT1 may enable light emitted from the opposite ends of each of the light emitting diodes LD, i.e., the first and second ends EP1 and EP2, to travel in a direction (e.g., in a frontal direction) in which an image is displayed. Particularly, if the first electrode ELT1 has an inclination corresponding to the shape of the first partition wall PW1, light emitted from the first end EP1 of each light emitting diode LD may be reflected by the first electrode ELT1 and more effectively travel in the frontal direction. Therefore, the efficiency of light emitted from the light emitting diodes LD may be enhanced.

Furthermore, if the first electrode ELT1 has a multi-layer structure including at least one transparent electrode layer disposed over and/or under the reflective electrode layer, a voltage drop due to a signal delay (RC delay) may be minimized. Therefore, a desired voltage can be effectively transmitted to the light emitting diodes LD. In an embodiment, the transparent electrode layer may be formed of various transparent conductive materials including ITO, and the constituent material thereof is not particularly limited.

In addition, if the first electrode ELT1 includes a conductive capping layer covering the reflective electrode layer and/or the transparent electrode layer, it is possible to prevent the reflective electrode layer of the first electrode ELT1 from being damaged due to defects caused during the process of manufacturing the pixel PXL. However, the conductive capping layer may be selectively included in the first electrode ELT1, and may be omitted in some embodiments. Furthermore, the conductive capping layer may be regarded as a component of the first electrode ELT1 or a separate component disposed on the first electrode ELT1.

The first insulating layer INS1 is disposed on the substrate SUB on which the first electrode ELT1 is formed. The first insulating layer INS1 is disposed on the substrate SUB to cover at least one area of the first electrode ELT1. In an embodiment, the first insulating layer INS1 may be disposed on the second partition wall PW2 such that one area of the first insulating layer INS1 is interposed between the second partition wall PW2 and the second electrode ELT2, but the present disclosure is not limited thereto. For example, in an embodiment, the first insulating layer INS1 may be disposed under the second partition wall PW2 such that the first insulating layer INS1 is interposed between the substrate SUB and the second partition wall PW2.

The first insulating layer INS1 may have a single-or multi-layer structure including at least one organic and/or inorganic layer and be formed of various known insulating materials. For example, the first insulating layer INS1 may include at least one inorganic layer formed of SiNₓ, but the present disclosure is not limited thereto. In other words, the first insulating layer INS1 may include various known insulating materials.

In an embodiment, the first insulating layer INS1 may include an opening which exposes one area of the first electrode ELT1. For example, the first insulating layer INS1 may have an opening corresponding to a predetermined first contact portion CNT1.

The second electrode ELT2 is disposed on the substrate SUB on which the first insulating layer INS1 is formed. In an embodiment, the second electrode ELT2 may be any one pixel electrode, e.g., one of an anode electrode and a cathode electrode. For example, if the first electrode ELT1 may be an anode electrode, the second electrode ELT2 may be a cathode electrode. In contrast, if the first electrode ELT1 may be a cathode electrode, the second electrode ELT2 may be an anode electrode.

The second electrode ELT2 is disposed on the first insulating layer INS1 at a position spaced apart from the first electrode ELT1. In other words, the second electrode ELT2 is disposed on a layer different from that of the first electrode ELT1 with the first insulating layer INS1 interposed therebetween.

Furthermore, the second electrode ELT2 is disposed on at least one area of the second partition wall PW2. For example, the second electrode ELT2 may be disposed on the second partition wall PW2 to completely cover the second partition wall PW2.

The second electrode ELT2 may have a shape corresponding to that of the second partition wall PW2. For example, the second electrode ELT2 may have an inclined surface or a curved surface corresponding to the shape of the second partition wall PW2. In a comparative example not forming part of the invention as claimed, the second partition wall PW2 may not be provided in the pixel PXL. In this case, the second electrode ELT2 may have a substantially planar shape.

In an embodiment, the second electrode ELT2 may have various conductive materials. For example, the second electrode ELT2 may have at least one reflective electrode layer, but the present disclosure is not limited thereto.

For instance, the second electrode ELT2 may include conductive material having a predetermined reflectivity. For example, the second electrode ELT2 may include at least one of a metal such as Ag, Mg, Al, Pt, Pd, Au, Ni, Nd, Ir, Cr, or an alloy thereof, a conductive oxide such as indium tin oxide (ITO), indium zinc oxide (IZO), zinc oxide (ZnO), or indium tin zinc oxide (ITZO), and a conductive polymer such as PEDOT, but the present disclosure is not limited thereto. In other words, the material for forming the second electrode ELT2 is not particularly limited, and the second electrode ELT2 may have various well-known electrode materials. Furthermore, the second electrode ELT2 may include the same conductive material as that of the first electrode ELT1, or include a conductive material different from that of the first electrode ELT1.

Furthermore, the second electrode ELT2 may be configured of a single layer or multiple layers, and the stacked structure thereof is not limited thereto. For example, the second electrode ELT2 may have a multi-layer structure including at least one reflective electrode layer and at least one conductive capping layer. Furthermore, the second electrode ELT2 may selectively further include at least one transparent electrode layer.

For example, the second electrode ELT2 may include at least one reflective electrode layer, at least one transparent electrode layer disposed over and/or under the reflective electrode layer, and at least one conductive capping layer configured to cover an upper portion of the reflective electrode layer and/or the transparent electrode layer. In an embodiment, the reflective electrode layer may be formed of various conductive materials, e.g., Ag, having reflectivity, and the constituent material thereof is not particularly limited.

In the case where the second electrode ELT2 includes a reflective electrode layer, the second electrode ELT2 may enable light emitted from the opposite ends of each of the light emitting diodes LD, i.e., the first and second ends EP1 and EP2, to travel in a direction (e.g., a frontal direction) in which an image is displayed. Particularly, if the second electrode ELT2 has an inclination corresponding to the shape of the second partition wall PW2, light emitted from the second end EP2 of each light emitting diode LD may be reflected by the second electrode ELT2 and more effectively travel in the frontal direction. Therefore, the efficiency of light emitted from the light emitting diodes LD may be enhanced.

Furthermore, if the second electrode ELT2 has a multi-layer structure including at least one transparent electrode layer disposed over and/or under the reflective electrode layer, a voltage drop due to a signal delay (RC delay) may be minimized. Thus, a desired voltage can be effectively transmitted to the light emitting diodes LD. In an embodiment, the transparent electrode layer may be formed of various transparent conductive materials including ITO, and the constituent material thereof is not particularly limited.

In addition, if the second electrode ELT2 includes a conductive capping layer covering the reflective electrode layer and/or the transparent electrode layer, it is possible to prevent the reflective electrode layer of the second electrode ELT2 from being damaged due to defects caused during the process of manufacturing the pixel PXL. However, the conductive capping layer may be selectively included in the second electrode ELT2, and may be omitted in some embodiments. Furthermore, the conductive capping layer may be regarded as a component of the second electrode ELT2 or a separate component disposed on the second electrode ELT2.

At least one light emitting diode LD is disposed on the substrate SUB on which the second electrode ELT2 is formed. For example, a plurality of light emitting diodes LD may be disposed in each pixel area in which each pixel PXL is formed.

According to the invention, the light emitting diodes LD are arranged between the first electrode ELT1 and the second electrode ELT2 in the horizontal direction in a plan view (e.g., when viewed from above the substrate SUB). For example, each light emitting diode LD has a first end EP1 and a second end EP2 on opposite sides with respect to the longitudinal direction thereof. The first end EP1 of the light emitting diode LD may be disposed to face the first electrode ELT1, and the second end EP2 of the light emitting diode LD may be disposed to face the second electrode ELT2.

The second contact electrode CNE2 is disposed on the substrate SUB on which the light emitting diodes LD are disposed. According to the invention, the second contact electrode CNE2 is disposed to cover the second ends EP2 of the light emitting diodes LD and at least one area of the second electrode ELT2.

According to the invention, the second contact electrode CNE2 is disposed over the light emitting diodes LD and the second electrode ELT2 such that the second contact electrode CNE2 directly contacts the second ends EP2 of the light emitting diodes LD and the at least one area of the second electrode ELT2. One area of the second contact electrode CNE2 is disposed on the second ends EP2 of the light emitting diodes LD and thus be brought into contact with the second ends EP2. Another area of the second contact electrode CNE2 is disposed on the second electrode ELT2 in a second contact portion CNT2 and thus be brought into direct contact with the second electrode ELT2. The second contact electrode CNE2 may stably support the second ends EP2 of the light emitting diodes LD and electrically connects the second ends EP2 to the second electrode ELT2.

In an embodiment, the second contact electrode CNE2 may be substantially transparent or translucent. For example, the second contact electrode CNE2 may be formed of transparent conductive material including ITO or IZO, and may also be made of various known transparent conductive materials. Therefore, light generated from each light emitting diode LD may be emitted from the light emitting diode LD through the second contact electrode CNE2.

The second insulating layer INS2 may be disposed on the substrate SUB on which the second contact electrode CNE2 is formed. For example, the second insulating layer INS2 may be disposed on the second contact electrode CNE2 to cover at least the second contact electrode CNE2. One end of the second insulating layer INS2 may be interposed between the first contact electrode CNE1 and the second contact electrode CNE2. Therefore, the first contact electrode CNE1 and the second contact electrode CNE2 may be reliably separated from each other, so that electrical stability between the first contact electrode CNE1 and the second contact electrode CNE2 can be secured. In other words, a short-circuit defect between the first contact electrode CNE1 and the second contact electrode CNE2 may be prevented by the second insulating layer INS2.

In an embodiment, the second insulating layer INS2 may have a single- or multi-layer structure including at least one organic layer and/or inorganic layer and may be formed of various known insulating materials. For example, the second insulating layer INS2 may include at least one inorganic layer formed of SiNₓ, but the present disclosure is not limited thereto. In other words, the second insulating layer INS2 may include various known insulating materials. Furthermore, the second insulating layer INS2 may include the same insulating material as that of the first insulating layer INS1, or include an insulating material different from that of the first insulating layer INS1.

In the case where space is present between the first insulating layer INS1 and the light emitting diodes LD, the space may be filled with the second insulating layer INS2 during a process of forming the second insulating layer INS2. Consequently, the light emitting diodes LD may be more stably supported. Furthermore, in the case where the first insulating layer INS1 and the second insulating layer INS2 are formed of the same material, the first and second insulating layers INS1 and INS2 may form one integrated insulating layer rather than being divided into separate insulating layers under the light emitting diodes LD.

The first contact electrode CNE1 may be disposed on the substrate SUB on which the second insulating layer INS2 is formed. According to the invention, the first contact electrode CNE1 is disposed to cover the first ends EP1 of the light emitting diodes LD and at least one area of the first electrode ELT1.

According to the invention, the first contact electrode CNE1 is disposed over the light emitting diodes LD and the first electrode ELT1 such that the first contact electrode CNE1 directly contacts the first ends EP1 of the light emitting diodes LD and the at least one area of the first electrode ELT1. According to the invention, the one area of the first contact electrode CNE1 is disposed on the first ends EP1 of the light emitting diodes LD and brought into contact with the first ends EP1. Another area of the first contact electrode CNE1 is disposed on the first electrode ELT1 exposed through an opening of the first insulating layer INS1 to make direct contact with the first electrode ELT1. The first contact electrode CNE1 may stably support the first ends EP1 of the light emitting diodes LD and electrically connects the first ends EP1 to the first electrode ELT1.

In an embodiment, the first contact electrode CNE1 may be substantially transparent or translucent. For example, the first contact electrode CNE1 may be formed of transparent conductive material including ITO or IZO, and may also be made of various known transparent conductive materials. Therefore, light generated from each light emitting diode LD may be emitted from the light emitting diode LD through the first contact electrode CNE1. Furthermore, the first contact electrode CNE1 may include the same conductive material as that of the second contact electrode CNE2, or include a conductive material different from that of the second contact electrode CNE2.

At least one insulating layer is disposed on the substrate SUB on which the first and second contact electrodes CNE1 and CNE2 are formed. For example, the one surface of the substrate SUB on which the first and second contact electrodes CNE1 and CNE2 are formed may be covered with at least one insulating layer. In an embodiment, the at least one insulating layer may include an encapsulation layer ENC (or an overcoat layer).

The encapsulation layer ENC may be formed of a single layer or multiple layers. For example, the encapsulation layer ENC may be a thin film encapsulation layer which includes a plurality of inorganic insulating layers overlapping each other and at least one organic insulating layer interposed between the inorganic insulating layers. However, the constituent material and/or sectional structure of the encapsulation layer ENC is not particularly limited, and may be changed in various ways. In an embodiment, the encapsulation layer ENC may be formed to cover at least a display area (e.g., the DA of FIG. 4) and thus protect the pixels PXL. In an embodiment, not only the encapsulation layer ENC but also at least one passivation layer, optical layer, or the like may be disposed on the one surface of the substrate SUB on which the light emitting diodes LD or the like are disposed.

As described above, according to the invention, the first electrode ELT1 and the second electrode ELT2 are respectively disposed on different layers on the substrate SUB that are separated from each other with the first insulating layer INS1 interposed therebetween. As such, if the first electrode ELT1 and the second electrode ELT2 are separately disposed on different layers, a short-circuit defect between the first electrode ELT1 and the second electrode ELT2 may be effectively prevented from occurring at the process of fabricating the pixel PXL (or the light emitting device).

Furthermore, as described in the foregoing embodiment, if the first electrode ELT1 and the second electrode ELT2 are separately disposed on different layers, the distance between the first electrode ELT1 and the second electrode ELT2 which may be set taking into account a process margin or the like may be further reduced, compared to that of pixels of other embodiments (or light emitting devices of other embodiments) in which the first electrode ELT1 and the second electrode ELT2 are formed on the same layer. If the distance between the first electrode ELT1 and the second electrode ELT2 is reduced, a stronger electric field may be formed between the first electrode ELT1 and the second electrode ELT2 even in case that the voltages applied to the first electrode ELT1 and the second electrode ELT2 are the same as that of the foregoing embodiment. Therefore, the light emitting diode LD may be efficiently aligned between the first electrode ELT1 and the second electrode ELT2, and the quality of the alignment can be enhanced.

In other words, according to the foregoing embodiment, at least one light emitting diode LD may be reliably arranged between the first electrode ELT1 and the second electrode ELT2, and a short-circuit defect between the first electrode ELT1 and the second electrode ELT2 may be effectively prevented or mitigated.

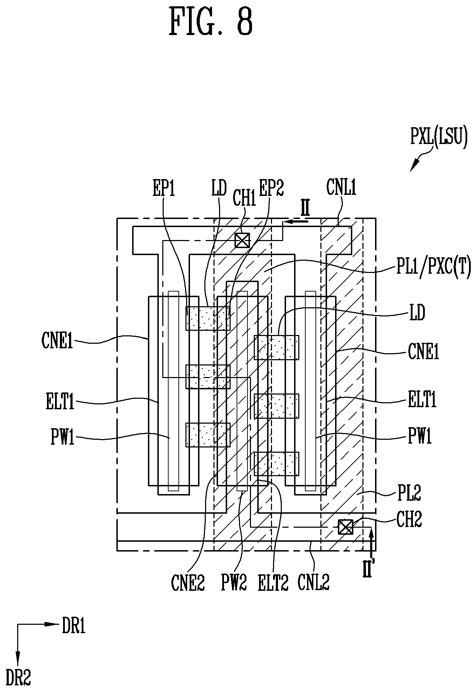

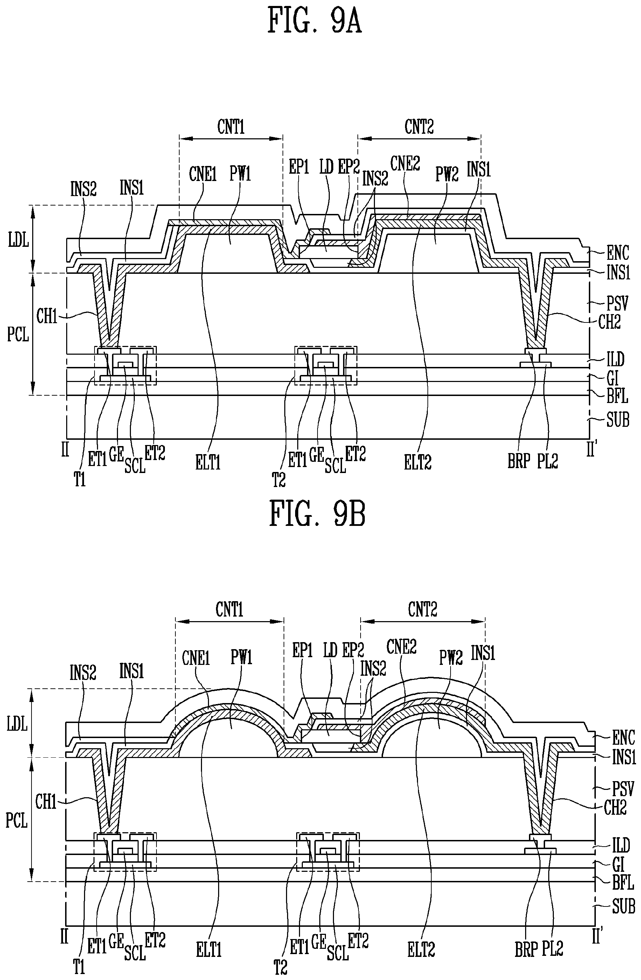

FIG. 8 is a plan view illustrating a light emitting device in accordance with an embodiment of the present disclosure and, for example, illustrates an example of a pixel PXL including the light emitting device. FIGS. 9A and 9B each are a sectional view illustrating a light emitting device in accordance with an embodiment of the present disclosure, and for example illustrate different embodiments of a cross-section corresponding to line II-II' of FIG. 8.

In an embodiment, FIGS. 8 to 9B illustrate a light emitting device (e.g., a pixel PXL of an active light emitting display device) in which first and/or second electrodes ELT1 and ELT2 are respectively connected to a first power line PL1 and a second power line PL2 through at least one contact hole, or the first and/or second electrodes ELT1 and ELT2 is connected to the first power line PL1 or the second power line PL2 via at least one circuit element (e.g., at least one transistor included in the pixel circuit PXC).

In an embodiment, the light source unit LSU illustrated in FIG. 8 may have a configuration substantially similar or identical to that of the light emitting device (or the pixel PXL) according to the above-described embodiment, e.g., the embodiment illustrated in FIG. 6. Furthermore, the display element layer LDL illustrated in FIGS. 9A and 9B may have a cross-section substantially similar or identical to that of the light emitting device (or the pixel PXL) according to the embodiment illustrated in FIGS. 7A and 7B. In the following description of the embodiment of FIGS. 8 to 9B, like reference numerals are used to indicate the identical or similar components to those of the embodiments of FIGS. 6 to 7B, and detailed descriptions thereof will be omitted.

Referring to FIGS. 4 to 9B, each pixel PXL includes a display element layer LDL including a first electrode ELT1, a second electrode ELT2, at least one light emitting diode LD, etc., and a circuit element layer PCL disposed under the display element layer LDL. For example, the circuit element layer PCL may be disposed between the substrate SUB and the display element layer LDL.

In an embodiment, the circuit element layer PCL may include a plurality of circuit elements disposed in the display area DA. For example, the circuit element layer PCL may include a plurality of circuit elements which are disposed in respective pixel areas to form the respective pixel circuits PXC. In other words, in an embodiment, the circuit element layer PCL may be a pixel circuit layer.

For example, the circuit element layer PCL may include a plurality of transistors disposed in each pixel area, e.g., the first and second transistors T1 and T2 of FIGS. 5A and 5B, and at least one capacitor, e.g., the storage capacitor Cst of FIGS. 5A and 5B. Furthermore, the circuit element layer PCL may further include at least one scan line Si, a data line Dj, a first power line PL1, and/or a second power line PL2.

In an embodiment, a plurality of transistors provided in each pixel circuit PXC, e.g., the first and second transistors T1 and T2, may have substantially the same or similar cross-sectional structure. However, the present disclosure is not limited thereto. In an embodiment, at least some of the plurality of transistors may have different types and/or structures.

In addition, the circuit element layer PCL may include a plurality of insulating layers. For example, the circuit element layer PCL may include a buffer layer BFL, a gate insulating layer GI, an interlayer insulating layer ILD, and a passivation layer PSV which are successively stacked on the one surface of the substrate SUB.

In an embodiment, the buffer layer BFL may prevent impurities from diffusing into each circuit element. The buffer layer BFL may be formed of a single layer, or may be formed of multiple layers having two or more layers. In the case where the buffer layer BFL has a multilayer structure, the respective layers may be formed of the same material or different materials. In an embodiment, the buffer layer BFL may be omitted.

In an embodiment, each of the first and second transistors T1 and T2 may include a semiconductor layer SCL, a gate electrode GE, a first transistor electrode ET1, and a second transistor electrode ET2. Although FIGS. 9A and 9B illustrate an embodiment in which each of the first and second transistors T1 and T2 includes the first transistor electrode ET1 and the second transistor electrode ET2 that are formed separately from the semiconductor layer SCL, the present disclosure is not limited thereto. For example, in an embodiment of the present disclosure, the first and/or second transistor electrode ET1 and/or ET2 provided in at least one transistor that forms each pixel circuit PXC may be integrally formed with the corresponding semiconductor layer SCL.

The semiconductor layer SCL may be disposed on the buffer layer BFL. For example, the semiconductor layer SCL may be disposed between the gate insulating layer GI and the substrate SUB on which the buffer layer BFL is formed. The semiconductor layer SCL may include a first area contacting the first transistor electrode ET1, a second area contacting the second transistor electrode ET2, and a channel area disposed between the first and second areas. In an embodiment, one of the first and second areas may be a source area, and the other may be a drain area.

In an embodiment, the semiconductor layer SCL may be a semiconductor pattern formed of polysilicon, amorphous silicon, an oxide semiconductor, etc. The channel area of the semiconductor layer SCL may be an intrinsic semiconductor, which is an undoped semiconductor pattern. Each of the first and second areas of the semiconductor layer SCL may be a semiconductor pattern doped with a predetermined impurity.

The gate electrode GE may be disposed on the semiconductor layer SCL with the gate insulating layer GI interposed therebetween. For example, the gate electrode GE may be disposed between the gate insulating layer GI and the interlayer insulating layer ILD and overlap at least one area of the semiconductor layer SCL.

The first and second transistor electrodes ET1 and ET2 may be disposed over the semiconductor layer SCL and the gate electrode GE with at least one interlayer insulating layer ILD interposed therebetween. For example, the first and second transistor electrodes ET1 and ET2 may be disposed between the interlayer insulating layer ILD and the passivation layer PSV. The first and second transistor electrodes ET1 and ET2 may be electrically connected to the semiconductor layer SCL. For example, the first and second transistor electrodes ET1 and ET2 may be respectively connected to the first area and the second area of the semiconductor layer SCL through corresponding contact holes which pass through the gate insulating layer GI and the interlayer insulating layer ILD.

In an embodiment, any one of the first and second transistor electrodes ET1 and ET2 of at least one transistor (e.g., the first transistor T1 of FIGS. 5A and 5B) provided in the pixel circuit PXC may be electrically connected, through the first contact hole CH1 passing through the passivation layer PSV, to the first electrode ELT1 of the light source unit LSU disposed on the passivation layer PSV.

In an embodiment, at least one signal line and/or power line that is connected to each pixel PXL may be disposed on a layer identical to that of one electrode of each of the circuit elements that form the pixel circuit PXC. For example, the second power line PL2 for supplying the second power supply VSS may be disposed on a layer identical with that of the gate electrodes GE of the first and second transistors T1 and T2 and may be electrically connected to the second electrode ELT2 of the light source unit LSU that is disposed on the passivation layer PSV, both through a bridge pattern BRP disposed on the layer identical to that of the first and second transistor electrodes ET1 and ET2 and through at least one second contact hole CH2 passing through the passivation layer PSV. However, the structure and/or position of the second power line PL2 may be changed in various ways.

The display element layer LDL may be a layer on which the light source unit LSU of each pixel PXL is disposed and, for example, may be configured in a manner identical to that of the light emitting device of the pixel PXL described with reference to FIGS. 6 to 7B. For example, the display element layer LDL may include at least one pair of first and second electrodes ELT1 and ELT2 disposed in each pixel area over the circuit element layer PCL, and at least one light emitting diode LD electrically connected between the first and second electrodes ELT1 and ELT2. For example, the display element layer LDL may include a plurality of light emitting diodes LD which are disposed over the circuit element layer PCL in each pixel area and configure each light source unit LSU. In addition, the display element layer LDL may further include, e.g., at least one insulating layer (or an insulating pattern) and/or electrode. For example, the display element layer LDL may further include at least one of the first and second partition walls PW1 and PW2, the first and second insulating layers INS1 and INS2, the first and second contact electrodes CNE1 and CNE2, and the encapsulation layer ENC that are described with reference to FIGS. 6 to 7B.

In the above-mentioned embodiment, the light source unit LSU of each pixel PXL may be configured of a light emitting device including at least one light emitting diode LD. Since the light emitting device according to an embodiment of the present disclosure has been described above, detailed descriptions of each light source unit LSU corresponding to the light emitting device and the display element layer LDL for configuring the light source unit LSU will be omitted.

In an embodiment, at least one first circuit element and/or line disposed in the circuit element layer PCL may overlap the first and/or second electrodes ELT1 and ELT2 of the display element layer LDL. For example, the first transistor T1 may overlap one area of the first electrode ELT1 (or the first connection electrode CNL1) and may be electrically connected to the first electrode ELT1 through the first contact hole CH1. Alternatively, in an embodiment, in case that the first electrode ELT1 is directly connected to the first power line PL1, one area of the first power line PL1 may overlap the first electrode ELT1 and may be electrically connected to the first electrode ELT1 through at least one contact hole.

In an embodiment, the second power line PL2 may overlap one area of the second electrode ELT2 (or the second connection electrode CNL2) and may be electrically connected to the second electrode ELT2 through the second contact hole CH2. In an embodiment, the second electrode ELT2 may be connected to the second power line PL2 via at least one second circuit element. In this case, the second circuit element may overlap one area of the second electrode ELT2 (or the second connection electrode CNL2) and may be electrically connected to the second electrode ELT2 through at least one contact hole.

In an embodiment, the first circuit element or the one area of the first power line PL1 that is electrically connected to the first electrode ELT1 may overlap the second electrode ELT2. Here, the first circuit element or the first power line PL1 may remain physically separated and/or electrically disconnected from the second electrode ELT2 by at least one insulating layer (e.g., at least a passivation layer PSV). Likewise, the second circuit element or the one area of the second power line PL2 that is electrically connected to the second electrode ELT2 may overlap the first electrode ELT1. Here, the second circuit element or the second power line PL2 may remain physically separated and/or electrically disconnected from the first electrode ELT1 by at least one insulating layer. As such, if the circuit element layer PCL and the display element layer LDL are disposed to overlap each other, the limited pixel area that is limited may be more efficiently used.

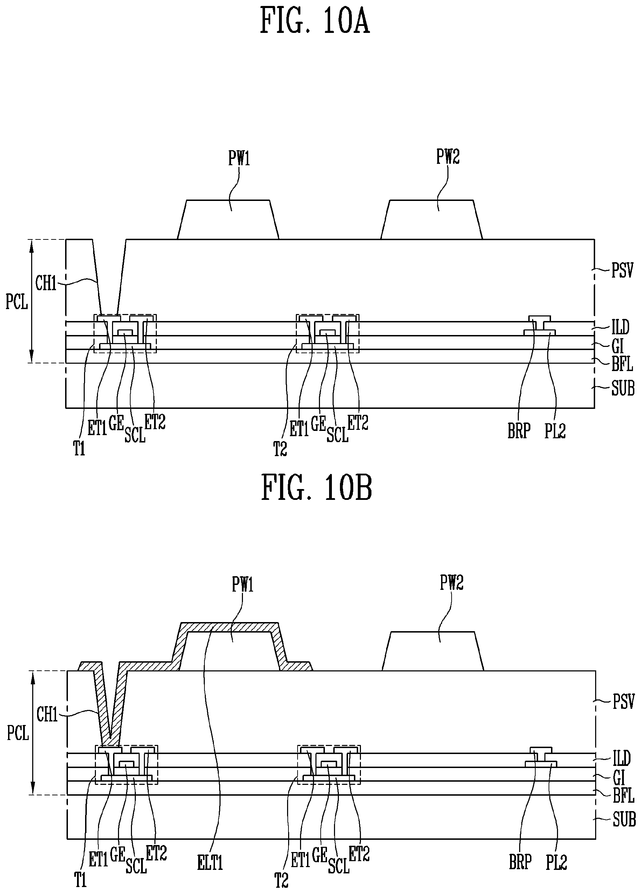

FIGS. 10A to 10K are sectional views illustrating a method of fabricating a light emitting device in accordance with an embodiment of the present disclosure, and, for example, illustrate a method of fabricating the light emitting device in accordance with the embodiment of FIG. 9A.

Referring to FIG. 10A along with FIG. 9A, the circuit element layer PCL is formed on the one surface of the substrate SUB, and the first and second partition walls PW1 and PW2 are formed at positions spaced apart from each other on the substrate SUB on which the circuit element layer PCL is formed. Furthermore, the first contact hole CH1 is formed to connect the first circuit element (e.g., the first transistor T1) of the circuit element layer PCL with any one electrode (e.g., the first electrode ELT1) of the display element layer LDL Here, in some embodiments, in the case where the circuit element layer PCL is omitted, the first and second partition walls PW1 and PW2 may be directly formed on the one surface of the substrate SUB (or the substrate SUB on which the buffer layer BFL is formed).

In an embodiment, the first and second partition walls PW1 and PW2 may be formed by a process of forming an insulating layer including an inorganic material and/or an organic material and/or a patterning process (e.g., a photolithography process), and may be formed by various types of known processes. In an embodiment, the first and second partition walls PW1 and PW2 may be simultaneously formed using the same material on the same layer (or the same plane) on the substrate SUB, but the present disclosure is not limited thereto.

Referring to FIG. 10B, the first electrode ELT1 is formed on the first partition wall PW1. Here, in some comparative examples not forming part of the invention as claimed, in the case where the circuit element layer PCL and/or the first partition wall PW1 is omitted, the first electrode ELT1 may be directly formed on the one surface of the substrate SUB (or the substrate SUB on which the buffer layer BFL is formed).

In an embodiment, the first electrode ELT1 is formed by a process of forming a conductive layer including at least one conductive material and/or a patterning process, and may be formed by various types of known processes. In an embodiment, the first electrode ELT1 may be formed of a single layer or multiple layers. For example, the first electrode ELT1 may be formed of a conductive pattern having a single-layer structure, or a conductive pattern having a multi-layer structure including a first reflective electrode and a first conductive capping layer.

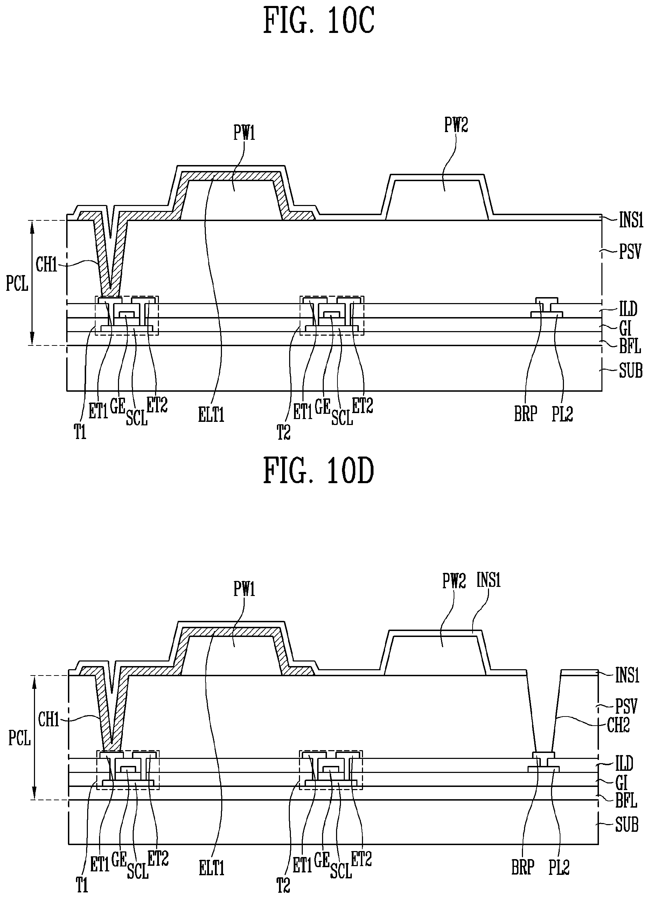

Referring to FIG. 10C, the first insulating layer INS1 is formed on the substrate SUB including the first electrode ELT1. According to the invention, the first insulating layer INS1 is formed on the one surface of the substrate SUB to cover at least the first electrode ELT1. For example, the first insulating layer INS1 may be formed on the entire area of each pixel area.

In an embodiment, the first insulating layer INS1 may be formed by a deposition process of an insulating layer including an inorganic material and/or an organic material and may be formed by various types of known processes. In an embodiment, the first insulating layer INS1 may be formed of a single layer or multiple layers.

Referring to FIG. 10D, the second contact hole CH2 is formed on the substrate SUB on which the first insulating layer INS1 is formed. For example, the second contact hole CH2 may be formed to expose the second power line PL2 or the bridge pattern BRP connected to the second power line PL2.

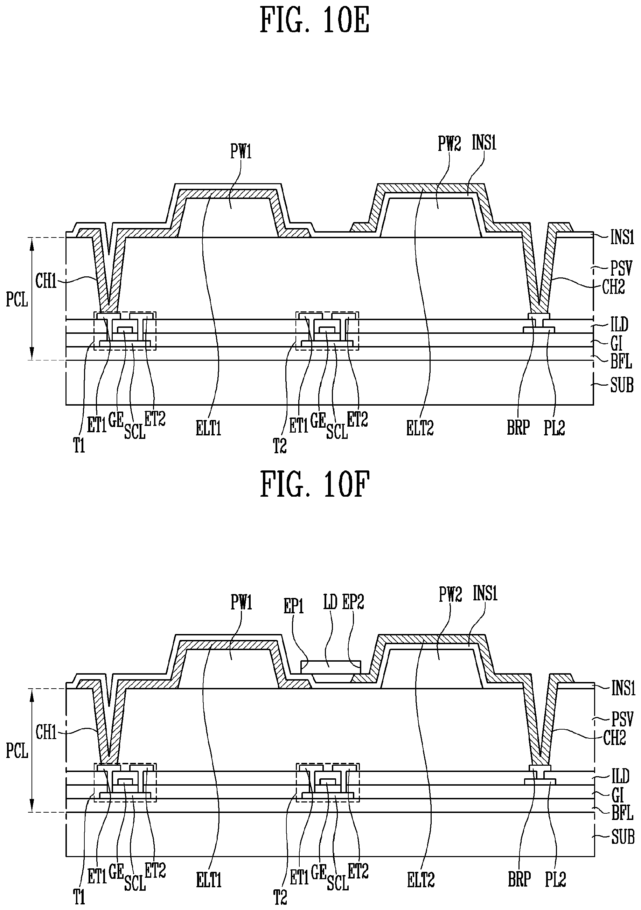

Referring to FIG. 10E, the second electrode ELT2 is formed on the first insulating layer INS1 including an opening corresponding to the second contact hole CH2. According to the invention, the second electrode ELT2 may be formed on the second partition wall PW2 and the second contact hole CH2. Furthermore, the second electrode ELT2 is formed at a position spaced apart from the first electrode ELT1 by a predetermined distance not to overlap the first electrode ELT1.

In an embodiment, the second electrode ELT2 is formed by a process of forming a conductive layer including at least one conductive material and/or a patterning process, and may be formed by various types of known processes. In an embodiment, the second electrode ELT2 may be formed of a single layer or multiple layers. For example, the second electrode ELT2 may be formed of a conductive pattern having a single-layer structure, or a conductive pattern having a multi-layer structure including a second reflective electrode and a second conductive capping layer.

Referring to FIG. 10F, at least one light emitting diode LD is supplied onto the substrate SUB including the first electrode ELT1, the second electrode ELT2, etc., and the light emitting diode LD is aligned between the first electrode ELT1 and the second electrode ELT2. For example, a plurality of light emitting diodes LD are supplied to each pixel area including the first and second electrodes ELT1 and ELT2, and the light emitting diodes LD may be aligned by applying predetermined voltages (e.g., AC voltages) to the first and second electrodes ELT1 and ELT2.

In an embodiment, the light emitting diodes LD may be supplied to a predetermined emission area (e.g., an emission area of each pixel PXL) by applying a solution with the plurality of light emitting diodes LD dispersed therein to the substrate SUB using an inkjet printing method, a slit coating method, or the like. However, the method of supplying the light emitting diodes LD is not limited thereto, and the light emitting diodes LD may be supplied onto one area of the substrate SUB in various other ways. In an embodiment, the electric field may be formed by applying AC voltages between the first and second electrodes ELT1 and ELT2, but the type of voltage or signal to be applied between the first and second electrodes ELT1 and ELT2 is not limited thereto.

In an embodiment, each light emitting diode LD may be aligned between the first and second electrodes ELT1 and ELT2 in a horizontal direction. For example, the first end EP1 of each of the light emitting diodes LD may be disposed to face the first electrode ELT1. The second end EP2 of each of the light emitting diodes LD may be disposed to face the second electrode ELT2.

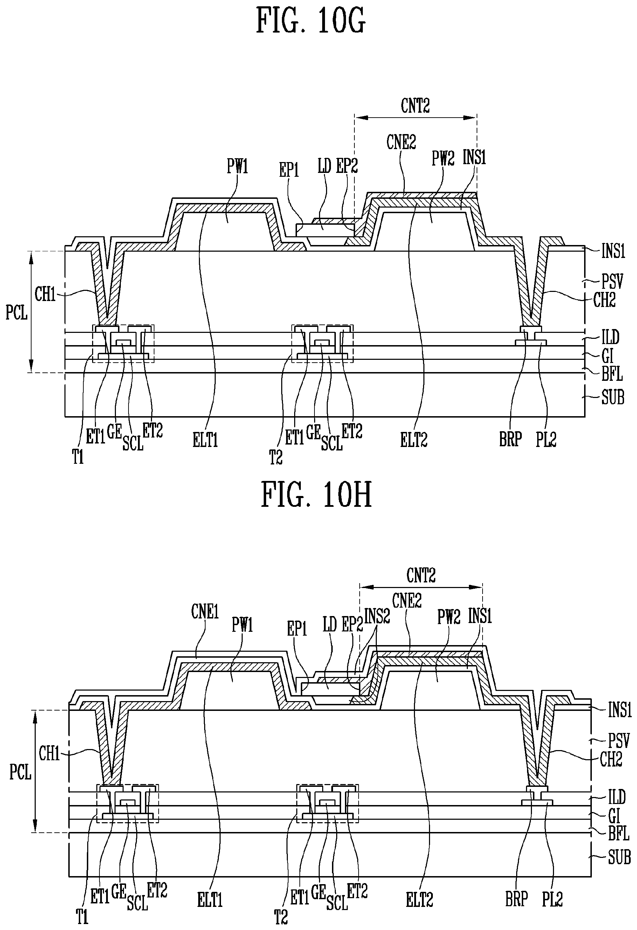

Referring to FIG. 10G, the second contact electrode CNE2 is formed on the substrate SUB on which at least one light emitting diode LD is disposed. According to the invention, to cover the second end EP2 of the light emitting diode LD and one area (e.g., a predetermined second contact portion CNT2) of the second electrode ELT2, the second contact electrode CNE2 is formed on the second end EP2 of the light emitting diode LD and at least one area of the second electrode ELT2. The second end EP2 of the light emitting diode LD is electrically connected to the second electrode ELT2 by the second contact electrode CNE2.

In an embodiment, the second contact electrode CNE2 is formed by a process of forming a conductive layer including at least one conductive material and/or a patterning process, and may be formed by various types of known processes. In an embodiment, the second contact electrode CNE2 may be formed to be substantially transparent using at least one transparent electrode material.

Referring to FIG. 10H, the second insulating layer INS2 is formed on the substrate SUB including the second contact electrode CNE2. For example, the second insulating layer INS2 may be formed on the one surface of the substrate SUB to cover at least the second contact electrode CNE2. In an embodiment, in the case where a space has been present between the first insulating layer INS1 and the light emitting diodes LD at a previous processing step, insulating material for forming the second insulating layer INS2 may be drawn into the space during a process of forming the second insulating layer INS2, so that the space may be filled with the insulating material.

In an embodiment, the second insulating layer INS2 may be formed by a deposition process of an insulating layer including an inorganic material and/or an organic material and may be formed by various types of known processes. The second insulating layer INS2 may be formed of a single layer or multiple layers.

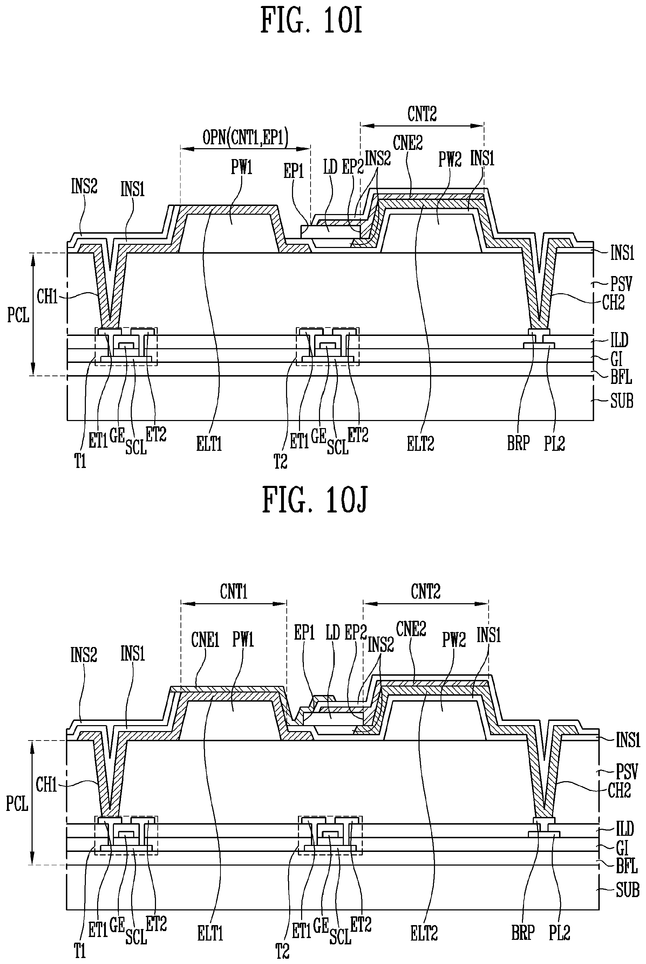

Referring to FIG. 10I, an opening OPN may be formed in the first and second insulating layers INS1 and INS2 by etching the first and second insulating layers INS1 and INS2 such that one area (e.g., a predetermined first contact portion CNT1) of the first electrode ELT1 and the first end EP1 of the light emitting diode LD are exposed. The first contact portion CNT1 is formed on the first electrode ELT1. In an embodiment, the first contact portion CNT1 may be formed by a photolithography process or the like, but the present disclosure is not limited thereto.

Referring to FIG. 10J, the first contact electrode CNE1 is formed both on at least one area of the first electrode ELT1 including the first contact portion CNT1 and on the first end EP1 of the light emitting diode LD. The first end EP1 of the light emitting diode LD is electrically connected to the first electrode ELT1 by the first contact electrode CNE1.

In an embodiment, the first contact electrode CNE1 is formed by a process of forming a conductive layer including at least one conductive material and/or a patterning process, and may be formed by various types of known processes. In an embodiment, the first contact electrode CNE1 may be formed to be substantially transparent using at least one transparent electrode material.

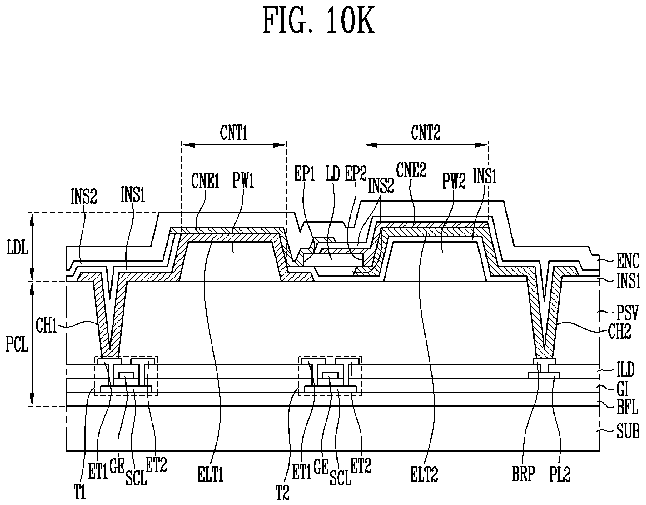

Referring to FIG. 10K, the encapsulation layer ENC (or the overcoat layer or the like) is formed on the one surface of the substrate SUB on which the first and second contact electrodes CNE1 and CNE2 are formed.

In an embodiment, the encapsulation layer ENC may be formed through a deposition process of an insulating layer including an inorganic material and/or an organic material, and may be formed by various types of known processes. The encapsulation layer ENC may be formed of a single layer or multiple layers. In an embodiment, in lieu of the encapsulation layer ENC, at least one other passivation layer and/or encapsulation substrate may be formed on the one surface of the substrate SUB on which the first and second contact electrodes CNE1 and CNE2 are formed.

By the above-mentioned process, the light emitting device according to an embodiment of the present disclosure may be fabricated. For example, the display panel PNL including the pixel PXL illustrated in FIGS. 8 and 9A may be fabricated.

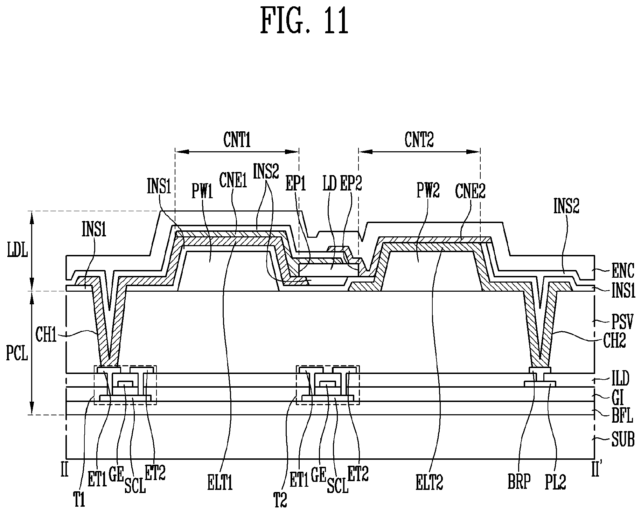

FIG. 11 is a sectional view illustrating a light emitting device in accordance with an embodiment of the present disclosure and for example illustrates an embodiment of a cross-section corresponding to line II-II' of FIG. 8. In an embodiment, FIG. 11 illustrates an embodiment different from that of FIG. 9A with regard to the positions of the first and second electrodes ELT1 and ELT2 on layers and the positions of the first and second contact electrodes CNE1 and CNE2 on layers. In the description of the embodiment of FIG. 11, like reference numerals are used to designate components similar or identical to those of the above-described embodiments, e.g., the embodiment of FIG. 9A, and detailed descriptions thereof will be omitted.

Referring to FIG. 11 along with FIGS. 8 and 9A, the positions (the stacked sequence) of the first electrode ELT1 and the second electrode ELT2 on layers may be changed depending on embodiments. For example, the second electrode ELT2 may be directly disposed on the second partition wall PW2, and the first insulating layer INS1 may be disposed to cover at least one area of the second electrode ELT2. The first electrode ELT1 may be disposed on the first insulating layer INS1 to overlap the first partition wall PW1.

In an embodiment, the positions of the first electrode ELT1 and the second electrode ELT2 on layers may be determined taking into account a surface area in which the first and second electrodes ELT1 and ELT2 overlap circuit elements and/or lines disposed thereunder. For example, as illustrated in FIG. 8, in case that the first electrode ELT1 overlaps, by a first surface area, the second power line PL2 (or at least one second circuit element) that is supplied with a signal different from that supplied to the first electrode ELT1, and the second electrode ELT2 overlaps, by a second surface area, the first power line PL1 (or the first circuit element such as at least one transistor that forms the pixel circuit PXC) that is supplied with a signal different from that supplied to the second electrode ELT2, the positions of the first electrode ELT1 and the second electrode ELT2 on layers may be determined by comparing the size of the first surface area with that of the second surface area.

For instance, if the second surface area is greater than the first surface area, the second electrode ELT2 may be disposed on a layer higher than that of the first electrode ELT1, as illustrated in FIG. 9A. In contrast, if the first surface area is greater than the second surface area, the first electrode ELT1 may be disposed on a layer higher than that of the second electrode ELT2, as illustrated in FIG. 11. In the case where the first surface area is substantially equal to the second surface area, the positions of the first electrode ELT1 and the second electrode ELT2 on layers may be determined depending on a predetermined sequence, process conditions, or the like.

In other words, in an embodiment of the present disclosure, an electrode of the first and second electrodes ELT1 and ELT2 that is greater than the other in an overlapping area, in which the electrode overlaps at least one circuit element or line disposed on the circuit element layer PCL disposed thereunder and configured to be supplied with a different type of signal or power, may be disposed at a position farther from the circuit element layer PCL than is the other. Therefore, an interlayer short-circuit defect due to penetration of foreign substances or the like in the processing step may be effectively prevented.

In an embodiment, the positions (or the stacked sequence) of the first contact electrode CNE1 and the second contact electrode CNE2 on the layers may be changed depending on embodiments. For example, as illustrated in the embodiment of FIG. 9A, the second contact electrode CNE2 may be formed on the second electrode ELT2, and the second contact electrode CNE2 may be covered with the second insulating layer INS2, and then the first contact electrode CNE1 may be formed on the second insulating layer INS2. Alternatively, as illustrated in the embodiment of FIG. 11, the first contact electrode CNE1 may be formed on the first electrode ELT1, and the first contact electrode CNE1 may be covered with the second insulating layer INS2, and then the second contact electrode CNE2 may be formed on the second insulating layer INS2. As a further alternative, in an embodiment, the first and second contact electrodes CNE1 and CNE2 may be simultaneously formed. In other words, in the present disclosure, the relative positions between the first contact electrode CNE1 and the second contact electrode CNE2 and/or the formation sequence thereof is not particularly limited, and may be changed in various ways.

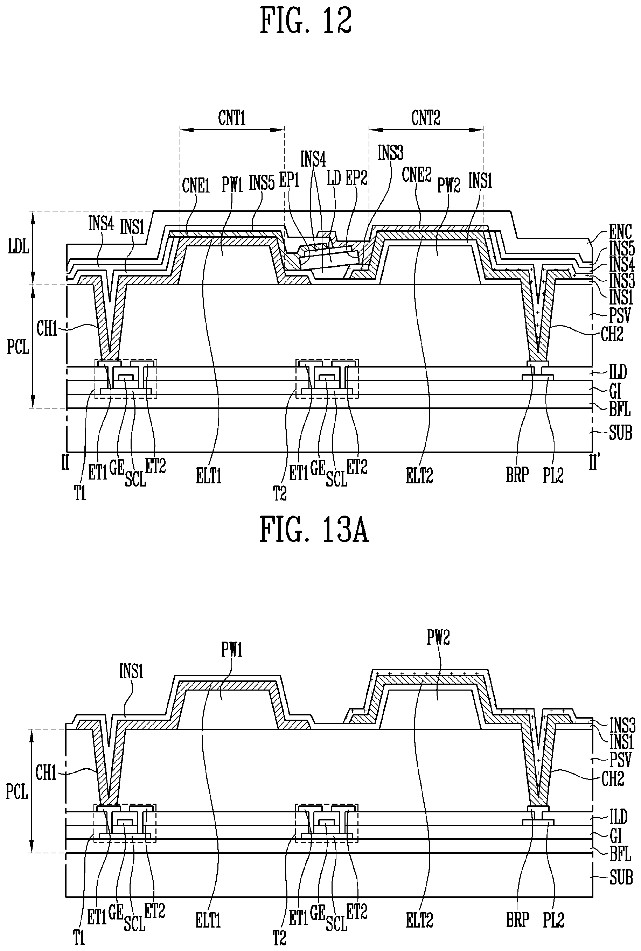

FIG. 12 is a sectional view illustrating a light emitting device in accordance with an embodiment of the present disclosure, and for example illustrates an embodiment of a cross-section corresponding to line II-II' of FIG. 8. In the description of the embodiment of FIG. 12, like reference numerals are used to designate components similar or equal to those of at least one embodiment described above, e.g., the embodiments of FIGS. 9A and 11, and detailed descriptions thereof will be omitted.

Referring to FIG. 12 along with FIGS. 9A and 11, at least one additional insulating layer may be disposed on any one electrode of the first and second electrodes ELT1 and ELT2 that is disposed at an upper position. For example, in the case where the second electrode ELT2 is disposed on a layer higher than that for the first electrode ELT1, a third insulating layer INS3 may be additionally disposed on the second electrode ELT2.

In an embodiment, the third insulating layer INS3 may include an opening corresponding to the second contact portion CNT2. In other words, the third insulating layer INS3 may be disposed on one area of the second electrode ELT2. For example, the third insulating layer INS3 may be disposed on one area of the second electrode ELT2 other than the second contact portion CNT2. One area of the third insulating layer INS3 may be disposed between the second end EP2 of the light emitting diode LD and one end of the second electrode ELT2 that is adjacent to the second end EP2. The third insulating layer INS3 may protect the second electrode ELT2 during a subsequent process. In an embodiment, the third insulating layer INS3 may prevent or reduce an electric field from being focused on any one electrode of the first electrode ELT1 and the second electrode ELT2.

In an embodiment, after at least one light emitting diode LD is aligned on the substrate SUB including the third insulating layer INS3, at least one insulating layer for stably supporting the light emitting diode LD may be further formed. For example, a fourth insulating layer INS4 may be further formed on the first and second electrodes ELT1 and ELT2 and one area of the light emitting diode LD.

In an embodiment, in the case where the first and second contact electrodes CNE1 and CNE2 are disposed on different layers, at least one insulating layer may be disposed between the first and second contact electrodes CNE1 and CNE2 so that electrical stability can be secured. For example, in the case where the first contact electrode CNE1 is disposed on a layer lower than the second contact electrode CNE2, a fifth insulating layer INS5 may be formed to cover the first contact electrode CNE1. In an embodiment, one end of the fifth insulating layer INS5 may be interposed between the first contact electrode CNE1 and the second contact electrode CNE2.

FIGS. 13A to 13I are sectional views illustrating a method of fabricating a light emitting device in accordance with an embodiment of the present disclosure, and for example illustrate a method of fabricating the light emitting device in accordance with the embodiment of FIG. 12. In the following description of the method of fabricating the light emitting device in accordance with the embodiment of FIG. 12, detailed descriptions of mechanical and/or methodical configuration similar or identical to those of the fabricating methods of the above-described embodiments, e.g., the fabricating method of the light emitting device of FIG. 9A that has been described with reference to FIGS. 10A to 10K, will be omitted.

Referring to FIG. 13A, the third insulating layer INS3 is formed on the one surface of the substrate SUB on which the first electrode ELT1, the first insulating layer INS1, and the second electrode ELT2 are sequentially formed. In an embodiment, although the first electrode ELT1, the first insulating layer INS1, the second electrode ELT2, etc. are formed by the fabricating process described with reference to FIGS. 10A to 10E, the present disclosure is not limited thereto.

In an embodiment, the third insulating layer INS3 may be formed on the one surface of the substrate SUB including the second electrode ELT2 to cover at least the second electrode ELT2. For example, the third insulating layer INS3 may be formed on the second electrode ELT2 through a photolithography process using a mask or the like.

In an embodiment, the third insulating layer INS3 may be formed by a deposition process of an insulating layer including an inorganic material and/or an organic material, and may be formed by various types of known processes. In an embodiment, the third insulating layer INS3 may be formed of a single layer or multiple layers.

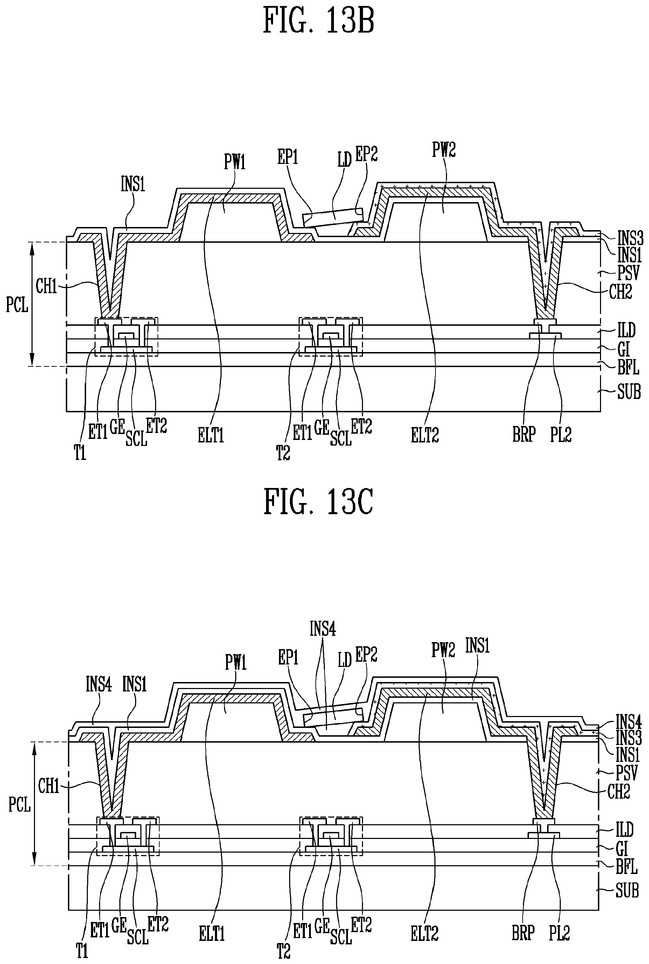

Referring to FIG. 13B, at least one light emitting diode LD is supplied on the substrate SUB including the first electrode ELT1 covered with the first insulating layer INS1, the second electrode ELT2 covered with the third insulating layer INS3, etc., and the light emitting diode LD is aligned between the first electrode ELT1 and the second electrode ELT2. For example, a plurality of light emitting diodes LD are supplied to each pixel area including the first and second electrodes ELT1 and ELT2, and the light emitting diodes LD may be aligned by applying predetermined voltages to the first and second electrodes ELT1 and ELT2.

Referring to FIG. 13C, the fourth insulating layer INS4 is formed on the substrate SUB on which the at least one light emitting diode LD is disposed. In an embodiment, the fourth insulating layer INS4 may be formed in the entire area of each pixel area. In an embodiment, in the case where a space has been present between the first insulating layer INS1 and the light emitting diodes LD in a previous processing step, insulating material for forming the fourth insulating layer INS4 may be drawn into the space during a process of forming the fourth insulating layer INS4, so that the space may be filled with the insulating material.

In an embodiment, the fourth insulating layer INS4 may be formed by a deposition process of an insulating layer including an inorganic material and/or an organic material and may be formed through various types of known processes. In an embodiment, the fourth insulating layer INS4 may be formed of a single layer or multiple layers.

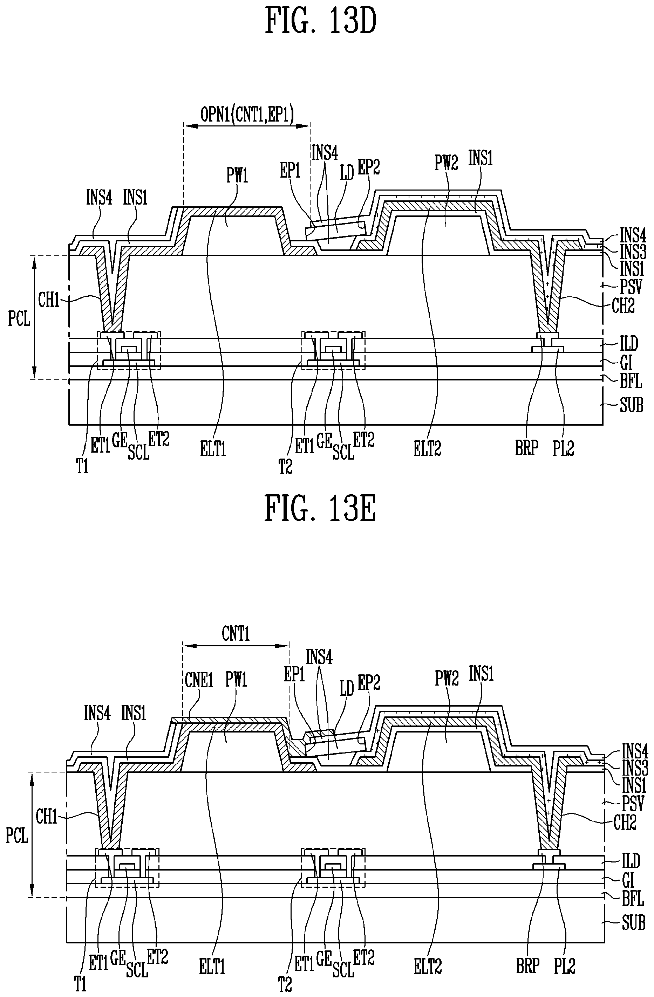

Referring to FIG. 13D, a first opening OPN1 may be formed in the first and fourth insulating layers INS1 and INS4 by etching the first and fourth insulating layers INS1 and INS4 such that one area of the first electrode ELT1 and the first end EP1 of the light emitting diode LD are exposed. The first contact portion CNT1 may be formed on the first electrode ELT1.

Referring to FIG. 13E, the first contact electrode CNE1 is formed both on at least one area of the first electrode ELT1 including the first contact portion CNT1 and on the first end EP1 of the light emitting diode LD. The first end EP1 of the light emitting diode LD is electrically connected to the first electrode ELT1 by the first contact electrode CNE1.

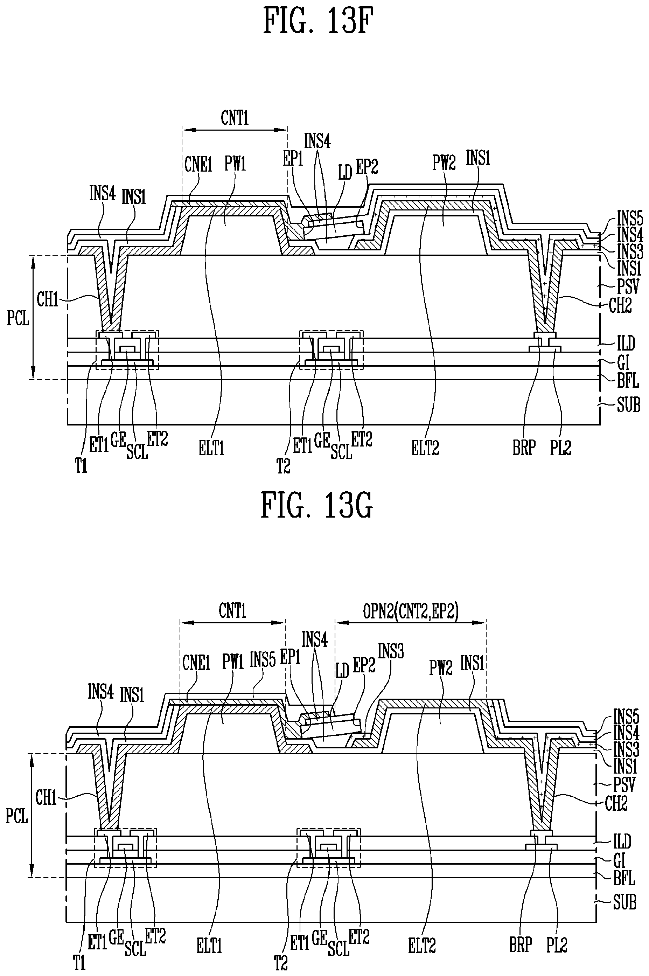

Referring to FIG. 13F, the fifth insulating layer INS5 is formed on the substrate SUB including the first contact electrode CNE1. In an embodiment, the fifth insulating layer INS5 may be formed to cover the first contact electrode CNE1. For example, the fifth insulating layer INS5 may be formed on the entire area of each pixel area.

In an embodiment, the fifth insulating layer INS5 may be formed by a deposition process of an insulating layer including an inorganic material and/or an organic material, and may be formed by various types of known processes. The fifth insulating layer INS5 may be formed of a single layer or multiple layers.

Referring to FIG. 13G, a second opening OPN2 is formed in the third, fourth, and the fifth insulating layers INS3, INS4, and INS5 by etching the third, fourth, and fifth insulating layers INS3, INS4, and INS5 such that one area of the second electrode ELT2 and the second end EP2 of the light emitting diode LD are exposed. The second contact portion CNT2 may be formed on the second electrode ELT2.

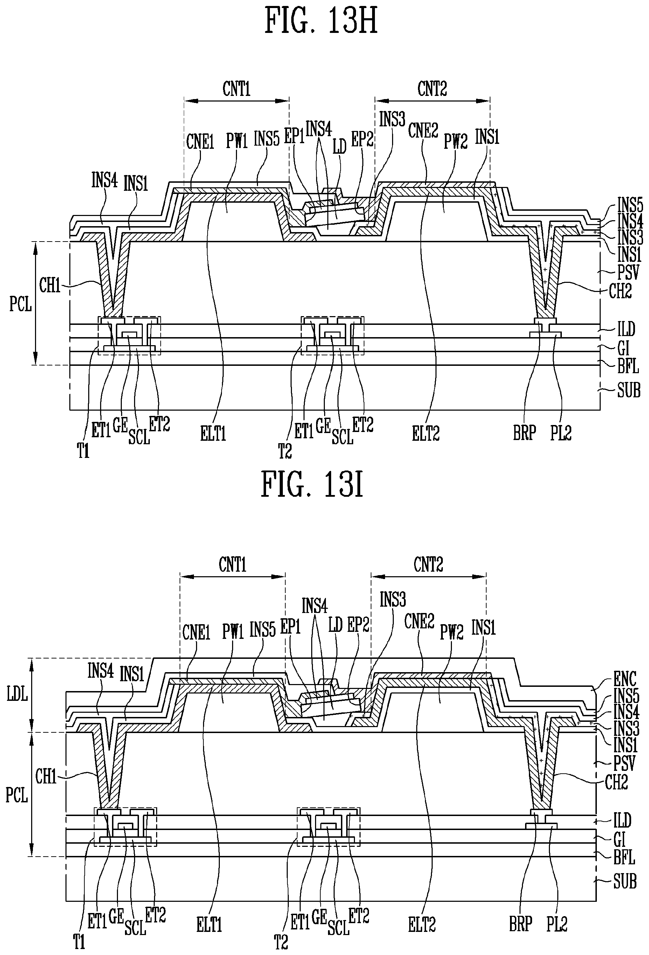

Referring to FIG. 13H, the second contact electrode CNE2 is formed both on at least one area of the second electrode ELT2 including the second contact portion CNT2 and on the second end EP2 of the light emitting diode LD. The second end EP2 of the light emitting diode LD is electrically connected to the second electrode ELT2 by the second contact electrode CNE2.

Referring to FIG. 13I, the encapsulation layer ENC (or the overcoat layer or the like) is formed on the one surface of the substrate SUB on which the first and second contact electrodes CNE1 and CNE2 are formed. In this way, the light emitting device (or the pixel PXL) in accordance with the embodiment of FIG. 12 may be fabricated.

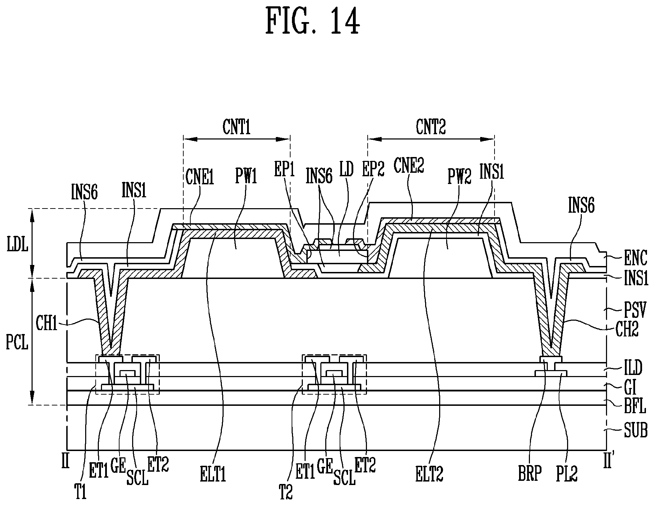

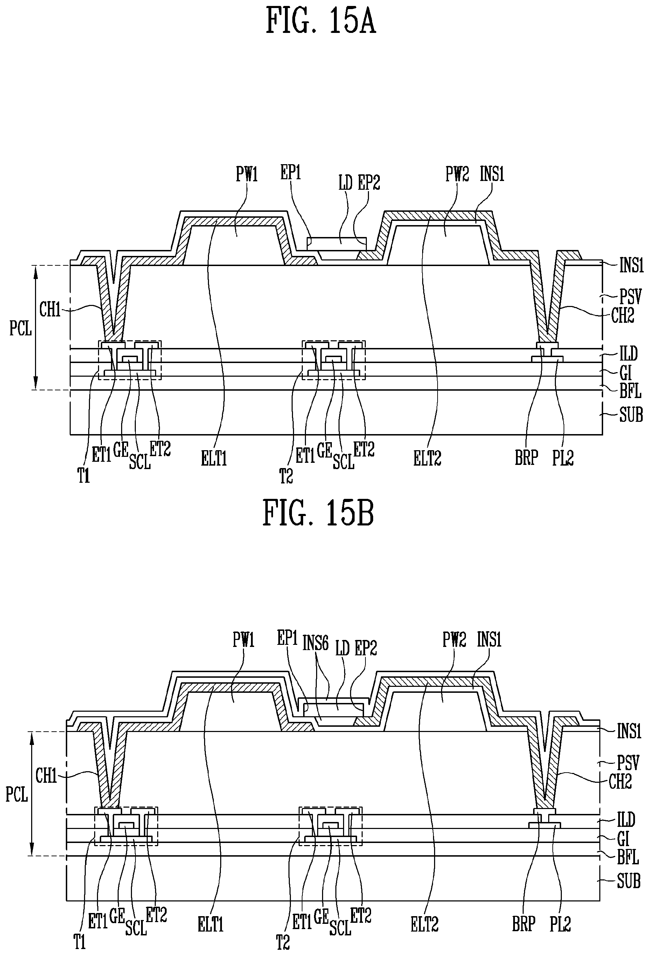

FIG. 14 is a sectional view illustrating a light emitting device in accordance with an embodiment of the present disclosure and, for example, illustrates an embodiment of a cross-section corresponding to line II-II' of FIG. 8. FIGS. 15A to 15E are sectional views illustrating a method of fabricating a light emitting device in accordance with an embodiment of the present disclosure and, for example, illustrate a method of fabricating the light emitting device in accordance with the embodiment of FIG. 14. In the following description of the embodiment of FIGS. 14 to 15E, detailed descriptions of mechanical and/or methodical configuration similar or identical to that of at least one embodiment described above, e.g., the embodiment of FIGS. 9A to 10K, will be omitted

Referring to the embodiment of FIGS. 14 to 15E, the first and second contact electrodes CNE1 and CNE2 may be formed simultaneously by the same process. For example, a light emitting device in accordance with an embodiment of the present disclosure may include first and second partition walls PW1 and PW2, a first electrode ELT1, a first insulating layer INS1, a second electrode ELT2, at least one light emitting diode LD (e.g., a plurality of light emitting diodes LD), a sixth insulating layer INS6, first and second contact electrodes CNE1 and CNE2, and an encapsulation layer ENC which are sequentially disposed on one surface of the substrate SUB on which a buffer layer BFL, and/or a circuit element layer PCL, etc. are formed.

In an embodiment, the sixth insulating layer INS6 may be partially disposed on the first electrode ELT1, the second electrode ELT2, and one area of each light emitting diode LD. For example, the sixth insulating layer INS6 may be partially disposed on the first electrode ELT1 and the second electrode ELT2 to respectively expose the first contact portion CNT1 and the second contact portion CNT2. Furthermore, the sixth insulating layer INS6 may be partially disposed on the light emitting diode LD to expose the first end EP1 and the second end EP2 of the light emitting diode LD. In an embodiment, in case that a space is present between the first insulating layer INS1 and the light emitting diodes LD, the space may be filled with the sixth insulating layer INS6 during a process of forming the sixth insulating layer INS6. Therefore, one area of the sixth insulating layer INS6 may also be disposed under the light emitting diode LD. In the case where the first insulating layer INS1 and the sixth insulating layer INS6 are formed of the same material, the first and sixth insulating layers INS1 and INS6 may form one integrated insulating layer rather than being divided into separate insulating layers under the light emitting diodes LD.

In an embodiment, one end of the first contact electrode CNE1 may be disposed on one area of the sixth insulating layer INS6 disposed on the light emitting diode LD. Furthermore, one end of the second contact electrode CNE2 may be disposed on one area of the sixth insulating layer INS6 positioned on the light emitting diode LD and may be disposed to face the first contact electrode CNE1.

Hereinafter, a method of fabricating the light emitting device in accordance with an embodiment of FIG. 14 will be described in more detail with reference to FIGS. 15A to 15E.

Referring to FIG. 15A, at least one light emitting diode LD is supplied on the one surface of the substrate SUB on which the first electrode ELT1, the first insulating layer INS1, the second electrode ELT2, etc., are sequentially formed, and the light emitting diode LD is aligned between the first electrode ELT1 and the second electrode ELT2. For example, a plurality of light emitting diodes LD are supplied to each pixel area including the first and second electrodes ELT1 and ELT2, and the light emitting diodes LD may be aligned by applying predetermined voltages to the first and second electrodes ELT1 and ELT2.

Referring to FIG. 15B, the sixth insulating layer INS6 is formed on the substrate SUB on which the at least one light emitting diode LD is disposed. In an embodiment, the sixth insulating layer INS6 may be formed in the entire area of each pixel area. In an embodiment, in the case where a space has been present between the first insulating layer INS1 and the light emitting diodes LD in a previous processing step, insulating material for forming the sixth insulating layer INS6 may be drawn into the space during a process of forming the sixth insulating layer INS6, so that the space may be filled with the insulating material.

In an embodiment, the sixth insulating layer INS6 may be formed by a deposition process of an insulating layer including an inorganic material and/or an organic material, and may be formed by various types of known processes. In an embodiment, the sixth insulating layer INS6 may be formed of a single layer or multiple layers.

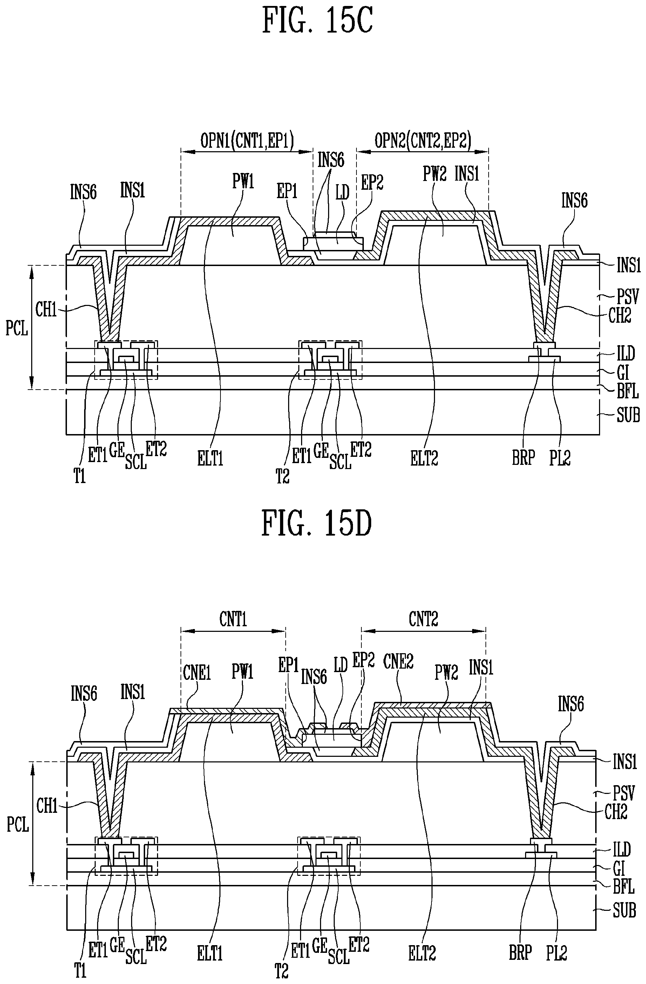

Referring to FIG. 15C, first and second openings OPN1 and OPN2 are formed in the first and sixth insulating layers INS1 and INS6 by etching the first and sixth insulating layers INS1 and INS6 such that one area of each of the first and second electrodes ELT1 and ELT2 and the first and second ends EP1 and EP2 of the light emitting diode LD are exposed. Therefore, the first contact portion CNT1 may be formed on the first electrode ELT1, and the second contact portion CNT2 may be formed on the second electrode ELT2.

Referring to FIG. 15D, the first contact electrode CNE1 is formed on at least one area of the first electrode ELT1 including the first contact portion CNT1 and on the first end EP1 of the light emitting diode LD. The second contact electrode CNE2 is formed on at least one area of the second electrode ELT2 including the second contact portion CNT2 and on the second end EP2 of the light emitting diode LD. In an embodiment, the first and second contact electrodes CNE1 and CNE2 may be simultaneously formed.

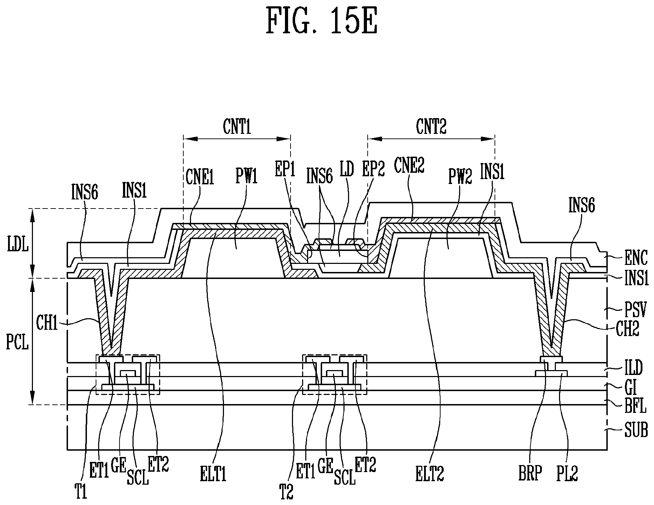

Referring to FIG. 15E, the encapsulation layer ENC (or the overcoat layer or the like) is formed on the one surface of the substrate SUB on which the first and second contact electrodes CNE1 and CNE2 are formed. In this way, the light emitting device (or the pixel PXL) in accordance with the embodiment of FIG. 14 may be fabricated.

In the light emitting device (e.g., the pixel PXL configured of the light emitting device or including the light emitting device), the method of fabricating the light emitting device, and the display device including the light emitting device, the first electrode ELT1 and the second electrode ELT2 are formed on different layers separated from each other, with the first insulating layer INS1 interposed between the first and second electrodes ELT1 and ELT2. In an embodiment of the present disclosure, an electrode of the first and second electrodes ELT1 and ELT2 that is greater than the other in an overlapping area, in which the electrode overlaps at least one circuit element or line disposed thereunder and configured to be supplied with a different type of signal or power, may be disposed on an upper layer.

In embodiments of the present disclosure, a short-circuit defect between the first electrode ELT1 and the second electrode ELT2 may be effectively prevented. Furthermore, a process margin between the first electrode ELT1 and the second electrode ELT2 may be reduced, so that the first electrode ELT1 and the second electrode ELT2 may be disposed closer to each other. Therefore, the light emitting diode LD may be more stably arranged between the first electrode ELT1 and the second electrode ELT2.

In the light emitting device according to an embodiment in which the first and second electrodes ELT1 and ELT2 are disposed on the same layer, a short-circuit defect between the first and second electrodes ELT1 and ELT2 may occur by various factors. For example, if the distance between the first and second electrodes ELT1 and ELT2 is not sufficient or penetration of foreign substances is caused in the process of forming the first and second electrodes ELT1 and ELT2 and/or a subsequent process, a short-circuit defect between the first and second electrodes ELT1 and ELT2 may occur.

While the scope of the present disclosure are described by detailed embodiments, it should be noted that the above-described embodiments are merely descriptive and should not be considered limiting. It should be understood by those skilled in the art that various changes, substitutions, and alternations may be made herein without departing from the scope of the disclosure as defined by the following claims.

The scope of the present disclosure is not limited by detailed descriptions of the present specification, and should be defined by the accompanying claims.

## Claims

1. A light emitting device comprising:
a substrate (SUB);
a first electrode (ELT1) disposed on the substrate (SUB);
a first insulating layer (INS1) disposed on the substrate (SUB) and configured to cover at least one area of the first electrode (ELT1);
a second electrode (ELT2) disposed on the first insulating layer (INS1) and spaced apart from the first electrode (ELT1); and
at least one light emitting diode (LD) electrically connected between the first electrode (ELT1) and the second electrode (ELT2),
wherein the first electrode (ELT1) and the second electrode (ELT2) are disposed on different layers on the substrate (SUB) with the first insulating layer (INS1) interposed therebetween, and are spaced apart from each other by a predetermined distance so as not to overlap each other in a plan view,
**characterized in that** the light emitting device further comprises:
a first partition wall (PW1) disposed between the substrate (SUB) and one area of the first electrode (ELT1);
a second partition wall (PW2) disposed between the substrate (SUB) and one area of the second electrode (ELT2);
a first contact electrode (CNE1) disposed on at least one area of the first electrode (ELT1) and a first end (EP1) of the light emitting diode (LD), and configured to electrically connect the first end (EP1) to the first electrode (ELT1); and
a second contact electrode (CNE2) disposed on at least one area of the second electrode (ELT2) and a second end (EP2) of the light emitting diode (LD), and configured to electrically connect the second end (EP2) to the second electrode (ELT2)).

2. A light emitting device according to claim 1, wherein:
the first partition wall (PW1) and the second partition wall (PW2) are disposed on a same layer on the substrate (SUB); and
wherein one area of the first insulating layer (INS1) is interposed between the second partition wall (PW2) and the second electrode (ELT2).

3. A light emitting device according to claim 1 or claim 2, comprising a display element layer (LDL) including the first electrode (ELT1), the second electrode (ELT2), and the light emitting diode (LD), and a circuit element layer (PCL) disposed between the display element layer (LDL) and the substrate (SUB),
wherein the circuit element layer (PCL) comprises:
a first circuit element or a first power line (PL1) electrically connected to the first electrode (ELT1), and including one area overlapping the second electrode (ELT2); and
a second circuit element or a second power line (PL2) electrically connected to the second electrode (ELT2), and including one area overlapping the first electrode (ELT1), optionally wherein an overlapping surface area between the first circuit element or the first power line (PL1) and the second electrode (ELT2) is greater than an overlapping surface area between the second circuit element or the second power line (PL2) and the first electrode (ELT1).

4. A light emitting device according to claim 1,
wherein the first insulating layer (INS1) includes an opening in which one area of the first electrode (ELT1) is exposed, and
wherein the first contact electrode (CNE1) contacts the exposed one area of the first electrode (ELT1) and the first end (EP1) of the light emitting diode (LD).

5. A light emitting device according to claim 1 or claim 4, further comprising a second insulating layer (INS2) disposed on the second contact electrode (CNE2) and configured to cover the second contact electrode (CNE2),
wherein one end of the second insulating layer (INS2) is interposed between the first contact electrode (CNE1) and the second contact electrode (CNE2).

6. A light emitting device according to any one of claims 1, 4, or 5, further comprising a third insulating layer (INS3) disposed on one area of the second electrode (ELT2).

7. A light emitting device according to claim 1, further comprising at least one of:
a fourth insulating layer (INS4) disposed on the first electrode (ELT1), the second electrode (ELT2), and one area of the light emitting diode (LD); and
a fifth insulating layer (INS5) configured to cover the first contact electrode (CNE1) and including one end interposed between the first contact electrode (CNE1) and the second contact electrode (CNE2).

8. A light emitting device according to claim 1, further comprising a sixth insulating layer (INS6) partially disposed on the first electrode (ELT1), the second electrode (ELT2), and one area of the light emitting diode (LD), and configured to expose one area of each of the first electrode (ELT1) and the second electrode (ELT2), and the first end (EP1) and the second end (EP2) of the light emitting diode (LD), optionally wherein:
one end of the first contact electrode (CNE1) is disposed on one area of the sixth insulating layer (INS6) that is disposed on the light emitting diode (LD); and
wherein one end of the second contact electrode (CNE2) is disposed, to face the first contact electrode (CNE1), on the one area of the sixth insulating layer (INS6) that is disposed on the light emitting diode (LD).

9. A light emitting device according to any one of claims 1, or 4 to 8, further comprising at least one encapsulation layer (ENC) configured to cover one surface of the substrate (SUB) on which the first contact electrode (CNE1) and the second contact electrode (CNE2) are disposed.

10. A light emitting device according to any one of claims 1 to 9, wherein the light emitting diode (LD) comprises a rod-type light emitting diode oriented in a horizontal direction between the first electrode (ELT1) and the second electrode (ELT2).

11. A method of fabricating a light emitting device, comprising:
forming a first electrode (ELT1) on a substrate (SUB);
forming a first insulating layer (INS1) on the substrate (SUB) to cover at least the first electrode (ELT1);
forming a second electrode (ELT2) on the first insulating layer (INS1) at a position spaced apart from the first electrode (ELT1) by a predetermined distance;
supplying a light emitting diode (LD) onto the substrate (SUB) including the first electrode (ELT1) and the second electrode (ELT2), and aligning the light emitting diode (LD) between the first electrode (ELT1) and the second electrode (ELT2);
forming a first contact electrode (CNE1) electrically connecting a first end (EP1) of the light emitting diode (LD) to the first electrode (ELT1), and a second contact electrode (CNE2) electrically connecting a second end (EP2) of the light emitting diode (LD) to the second electrode (ELT2);
forming a first partition wall (PW1) between the substrate (SUB) and one area of the first electrode (ELT1); and
forming a second partition wall (PW2) between the substrate (SUB) and one area of the second electrode (ELT2).

12. A method according to claim 11, wherein
(i) the forming of the first contact electrode (CNE1) comprises:
forming a first contact portion (CNT1) by etching the first insulating layer (INS1) such that one area of the first electrode (ELT1) is exposed; and
forming the first contact electrode (CNE1) on at least the one area of the first electrode (ELT1) including the first contact portion (CNT1) and on the first end (EP1) of the light emitting diode (LD); and/or
(ii) the forming of the second contact electrode (CNE2) comprises forming the second contact electrode (CNE2) on at least one area of the second electrode (ELT2) and the second end (EP2) of the light emitting diode (LD).

13. A method according to claim 11 or claim 12, wherein:
(i) the first contact electrode (CNE1) and the second contact electrode (CNE2) are sequentially formed on the substrate (SUB), or the first contact electrode (CNE1) and the second contact electrode (CNE2) are simultaneously formed on the substrate (SUB); and/or
(ii) the method further comprises, after the forming of the second electrode (ELT2), forming a third insulating layer (INS3) configured to cover the second electrode (ELT2),
wherein the light emitting diode (LD) is supplied onto the substrate (SUB) on which the third insulating layer (INS3) is formed.

14. A display device comprising:
the light emitting device of claims 1 to 10.

## Patentansprüche

1. Licht emittierende Vorrichtung, die Folgendes umfasst:
ein Substrat (SUB);
eine erste Elektrode (ELT1), die auf dem Substrat (SUB) angeordnet ist;
eine erste Isolierschicht (INS1), die auf dem Substrat (SUB) angeordnet ist und dazu konfiguriert ist, mindestens einen Bereich der ersten Elektrode (ELT1) zu bedecken;
eine zweite Elektrode (ELT2), die auf der ersten Isolierschicht (INS1) angeordnet ist und von der ersten Elektrode (ELT1) beabstandet ist; und
mindestens eine Leuchtdiode (LD), die elektrisch zwischen der ersten Elektrode (ELT1) und der zweiten Elektrode (ELT2) angeschlossen ist,
wobei die erste Elektrode (ELT1) und die zweite Elektrode (ELT2) auf unterschiedlichen Schichten des Substrats (SUB) angeordnet sind, wobei die erste Isolierschicht (INS1) dazwischen zwischengeschaltet ist, und um einen vorbestimmten Abstand voneinander beabstandet sind, um einander in einer Draufsicht nicht zu überlappen,
**dadurch gekennzeichnet, dass** die Licht emittierende Vorrichtung weiter Folgendes umfasst:
eine erste Trennwand (PW1), die zwischen dem Substrat (SUB) und einem Bereich der ersten Elektrode (ELT1) angeordnet ist;
eine zweite Trennwand (PW2), die zwischen dem Substrat (SUB) und einem Bereich der zweiten Elektrode (ELT2) angeordnet ist;
eine erste Kontaktelektrode (CNE1), die auf mindestens einem Bereich der ersten Elektrode (ELT1) und einem ersten Ende (EP1) der Leuchtdiode (LD) angeordnet ist und dazu konfiguriert ist, das erste Ende (EP1) elektrisch mit der ersten Elektrode (ELT1) zu verbinden; und
eine zweite Kontaktelektrode (CNE2), die auf mindestens einem Bereich der zweiten Elektrode (ELT2) und einem zweiten Ende (EP2) der Leuchtdiode (LD) angeordnet ist und dazu konfiguriert ist, das zweite Ende (EP2) elektrisch mit der zweiten Elektrode (ELT2) zu verbinden.

2. Licht emittierende Vorrichtung nach Anspruch 1, wobei:
die erste Trennwand (PW1) und die zweite Trennwand (PW2) auf derselben Schicht auf dem Substrat (SUB) angeordnet sind; und
wobei ein Bereich der ersten Isolierschicht (INS1) zwischen der zweiten Trennwand (PW2) und der zweiten Elektrode (ELT2) zwischengeschaltet ist.

3. Licht emittierende Vorrichtung nach Anspruch 1 oder 2, die eine Anzeigeelementschicht (LDL) umfasst, die die erste Elektrode (ELT1), die zweite Elektrode (ELT2) und die Leuchtdiode (LD) sowie eine Schaltungselementschicht (PCL), die zwischen der Anzeigeelementschicht (LDL) und dem Substrat (SUB) angeordnet ist, beinhaltet,
wobei die Schaltungselementschicht (PCL) Folgendes umfasst:
ein erstes Schaltungselement oder eine erste Stromleitung (PL1), das/die elektrisch mit der ersten Elektrode (ELT1) verbunden ist und einen Bereich beinhaltet, der die zweite Elektrode (ELT2) überlappt; und
ein zweites Schaltungselement oder eine zweite Stromleitung (PL2), das/die elektrisch mit der zweiten Elektrode (ELT2) verbunden ist und einen Bereich beinhaltet, der die erste Elektrode (ELT1) überlappt, wobei optional ein Überlappungsflächenbereich zwischen dem ersten Schaltungselement oder der ersten Stromleitung (PL1) und der zweiten Elektrode (ELT2) größer ist als der Überlappungsflächenbereich zwischen dem zweiten Schaltungselement oder der zweiten Stromleitung (PL2) und der ersten Elektrode (ELT1).

4. Licht emittierende Vorrichtung nach Anspruch 1,
wobei die erste Isolierschicht (INS1) eine Öffnung beinhaltet, in der ein Bereich der ersten Elektrode (ELT1) freigelegt ist, und
wobei die erste Kontaktelektrode (CNE1) den freigelegten einen Bereich der ersten Elektrode (ELT1) und das erste Ende (EP1) der Leuchtdiode (LD) kontaktiert.

5. Licht emittierende Vorrichtung nach Anspruch 1 oder Anspruch 4, die weiter eine zweite Isolierschicht (INS2) umfasst, die auf der zweiten Kontaktelektrode (CNE2) angeordnet und dazu konfiguriert ist, die zweite Kontaktelektrode (CNE2) zu bedecken,
wobei ein Ende der zweiten Isolierschicht (INS2 ) zwischen der ersten Kontaktelektrode (CNE1) und der zweiten Kontaktelektrode (CNE2) zwischengeschaltet ist.

6. Licht emittierende Vorrichtung nach einem der Ansprüche 1, 4 oder 5, die weiter eine dritte Isolierschicht (INS3) umfasst, die auf einem Bereich der zweiten Elektrode (ELT2) angeordnet ist.

7. Licht emittierende Vorrichtung nach Anspruch 1, die weiter mindestens eines der Folgenden umfasst:
eine vierte Isolierschicht (INS4), die auf der ersten Elektrode (ELT1), der zweiten Elektrode (ELT2) und einem Bereich der Leuchtdiode (LD) angeordnet ist; und
eine fünfte Isolierschicht (INS5), die dazu konfiguriert ist, die erste Kontaktelektrode (CNE1) abzudecken und die ein Ende beinhaltet, das zwischen der ersten Kontaktelektrode (CNE1) und der zweiten Kontaktelektrode (CNE2) zwischengeschaltet ist.

8. Licht emittierende Vorrichtung nach Anspruch 1, die weiter eine sechste Isolierschicht (INS6) umfasst, die teilweise auf der ersten Elektrode (ELT1), der zweiten Elektrode (ELT2) und einem Bereich der Leuchtdiode (LD) angeordnet ist und dazu konfiguriert ist, dass jeweils ein Bereich der ersten Elektrode (ELT1) und der zweiten Elektrode (ELT2) sowie das erste Ende (EP1) und das zweite Ende (EP2) der Leuchtdiode (LD) freigelegt sind, wobei optional:
ein Ende der ersten Kontaktelektrode (CNE1) auf einem Bereich der sechsten Isolierschicht (INS6), die auf der Leuchtdiode (LD) angeordnet ist, angeordnet ist; und
wobei ein Ende der zweiten Kontaktelektrode (CNE2) dazu angeordnet ist, der ersten Kontaktelektrode (CNE1) auf dem Bereich der sechsten Isolierschicht (INS6), der auf der Leuchtdiode (LD) angeordnet ist, zugewandt zu sein.

9. Licht emittierende Vorrichtung nach einem der Ansprüche 1 oder 4 bis 8, die weiter mindestens eine Verkapselungsschicht (ENC) umfasst, die dazu konfiguriert ist, eine Oberfläche des Substrats (SUB) zu bedecken, auf dem die erste Kontaktelektrode (CNE1) und die zweite Kontaktelektrode (CNE2) angeordnet sind.

10. Licht emittierende Vorrichtung nach einem der Ansprüche 1 bis 9, wobei die Leuchtdiode (LD) eine stabförmige Leuchtdiode umfasst, die in einer horizontalen Richtung zwischen der ersten Elektrode (ELT1) und der zweiten Elektrode (ELT2) ausgerichtet ist.

11. Verfahren zur Herstellung einer Licht emittierenden Vorrichtung, das Folgendes umfasst:
Bilden einer ersten Elektrode (ELT1) auf einem Substrat (SUB);
Bilden einer ersten Isolierschicht (INS1) auf dem Substrat (SUB), um mindestens die erste Elektrode (ELT1) zu bedenken;
Bilden einer zweiten Elektrode (ELT2) auf der ersten Isolierschicht (INS1) an einer Position, die von der ersten Elektrode (ELT1) durch einen vorbestimmten Abstand beabstandet ist;
Zuführen einer Leuchtdiode (LD) auf das Substrat (SUB) einschließlich der ersten Elektrode (ELT1) und der zweiten Elektrode (ELT2), und Ausrichten der Leuchtdiode (LD) zwischen der ersten Elektrode (ELT1) und der zweiten Elektrode (ELT2);
Bilden einer ersten Kontaktelektrode (CNE1), die ein erstes Ende (EP1) der Leuchtdiode (LD) elektrisch mit der ersten Elektrode (ELT1) verbindet, und einer zweiten Kontaktelektrode (CNE2), die ein zweites Ende (EP2) der Leuchtdiode (LD) elektrisch mit der zweiten Elektrode (ELT2) verbindet;
Bilden einer ersten Trennwand (PW1) zwischen dem Substrat (SUB) und einem Bereich der ersten Elektrode (ELT1); und
Bilden einer zweiten Trennwand (PW2) zwischen dem Substrat (SUB) und einem Bereich der zweiten Elektrode (ELT2).

12. Verfahren nach Anspruch 11, wobei
(i) das Bilden der ersten Kontaktelektrode (CNE1) Folgendes umfasst:
Bilden eines ersten Kontaktabschnitts (CNT1) durch Ätzen der ersten Isolierschicht (INS1) derart, dass ein Bereich der ersten Elektrode (ELT1) freigelegt wird; und
Bilden der ersten Kontaktelektrode (CNE1) auf mindestens dem einen Bereich der ersten Elektrode (ELT1) einschließlich des ersten Kontaktabschnitts (CNT1) und auf dem ersten Ende (EP1) der Leuchtdiode (LD); und/oder
(ii) wobei das Bilden der zweiten Kontaktelektrode (CNE2) das Bilden der zweiten Kontaktelektrode (CNE2) auf mindestens einem Bereich der zweiten Elektrode (ELT2) und dem zweiten Ende (EP2) der Leuchtdiode (LD) umfasst.

13. Verfahren nach Anspruch 11 oder Anspruch 12, wobei:
(i) die erste Kontaktelektrode (CNE1) und die zweite Kontaktelektrode (CNE2) nacheinander auf dem Substrat (SUB) gebildet werden, oder die erste Kontaktelektrode (CNE1) und die zweite Kontaktelektrode (CNE2) gleichzeitig auf dem Substrat (SUB) gebildet werden; und/oder
(ii) das Verfahren weiter nach dem Bilden der zweiten Elektrode (ELT2) das Bilden einer dritten Isolierschicht (INS3) umfasst, die dazu konfiguriert ist, die zweite Elektrode (ELT2) zu bedecken,
wobei die Leuchtdiode (LD) auf das Substrat (SUB), auf dem die dritte Isolierschicht (INS3) gebildet wird, zugeführt wird.

14. Anzeigevorrichtung, die Folgendes umfasst:
die Leuchtvorrichtung nach den Ansprüchen 1 bis 10.

## Revendications

1. Dispositif électroluminescent comprenant :
un substrat (SUB) ;
une première électrode (ELT1) disposée sur le substrat (SUB) ;
une première couche isolante (INS1) disposée sur le substrat (SUB) et configurée pour couvrir au moins une zone de la première électrode (ELT1) ;
une deuxième électrode (ELT2) disposée sur la première couche isolante (INS1) et espacée de la première électrode (ELT1) ; et
au moins une diode électroluminescente (LD) connectée électriquement entre la première électrode (ELT1) et la deuxième électrode (ELT2),
dans lequel la première électrode (ELT1) et la deuxième électrode (ELT2) sont disposées sur des couches différentes du substrat (SUB) avec la première couche isolante (INS1) interposée entre elles, et sont espacées l'une de l'autre d'une distance prédéterminée afin qu'elles ne se chevauchent pas dans une vue de dessus,
**caractérisé en ce que** le dispositif électroluminescent comprend en outre :
une première paroi de séparation (PW1) disposée entre le substrat (SUB) et une zone de la première électrode (ELT1) ;
une deuxième paroi de séparation (PW2) disposée entre le substrat (SUB) et une zone de la deuxième électrode (ELT2) ;
une première électrode de contact (CNE1) disposée sur au moins une zone de la première électrode (ELT1) et une première extrémité (EP1) de la diode électroluminescente (LD), et configurée pour connecter électriquement la première extrémité (EP1) à la première électrode (ELT1) ; et
une deuxième électrode de contact (CNE2) disposée sur au moins une zone de la deuxième électrode (ELT2) et une deuxième extrémité (EP2) de la diode électroluminescente (LD), et configurée pour connecter électriquement la deuxième extrémité (EP2) à la deuxième électrode (ELT2).

2. Dispositif électroluminescent selon la revendication 1, dans lequel :
la première paroi de séparation (PW1) et la deuxième paroi de séparation (PW2) sont disposées sur une même couche du substrat (SUB) ; et
dans lequel une zone de la première couche isolante (INS1) est interposée entre la deuxième paroi de séparation (PW2) et la deuxième électrode (ELT2).

3. Dispositif électroluminescent selon la revendication 1 ou la revendication 2, comprenant une couche d'éléments d'affichage (LDL) incluant la première électrode (ELT1), la deuxième électrode (ELT2) et la diode électroluminescente (LD), et une couche d'éléments de circuit (PCL) disposée entre la couche d'éléments d'affichage (LDL) et le substrat (SUB),
dans lequel la couche d'éléments de circuit (PCL) comprend :
un premier élément de circuit ou une première ligne d'alimentation (PL1) connectée électriquement à la première électrode (ELT1), et incluant une zone chevauchant la deuxième électrode (ELT2) ; et
un deuxième élément de circuit ou une deuxième ligne d'alimentation (PL2) électriquement connecté(e) à la deuxième électrode (ELT2), et incluant une zone chevauchant la première électrode (ELT1), en option dans lequel une surface de chevauchement entre le premier élément de circuit ou la première ligne d'alimentation (PL1) et la deuxième électrode (ELT2) est plus grande qu'une surface de chevauchement entre le deuxième élément de circuit ou la deuxième ligne d'alimentation (PL2) et la première électrode (ELT1).

4. Dispositif électroluminescent selon la revendication 1,
dans lequel la première couche isolante (INS1) inclut une ouverture dans laquelle une zone de la première électrode (ELT1) est exposée, et
dans lequel la première électrode de contact (CNE1) entre en contact avec la zone exposée de la première électrode (ELT1) et la première extrémité (EP1) de la diode électroluminescente (LD).

5. Dispositif électroluminescent selon la revendication 1 ou la revendication 4, comprenant en outre une deuxième couche isolante (INS2) disposée sur la deuxième électrode de contact (CNE2) et configurée pour recouvrir la deuxième électrode de contact (CNE2),
dans lequel une extrémité de la deuxième couche isolante (INS2) est interposée entre la première électrode de contact (CNE1) et la deuxième électrode de contact (CNE2).

6. Dispositif électroluminescent selon l'une quelconque des revendications 1, 4 ou 5, comprenant en outre une troisième couche isolante (INS3) disposée sur une zone de la deuxième électrode (ELT2).

7. Dispositif électroluminescent selon la revendication 1, comprenant en outre au moins un des éléments suivants :
une quatrième couche isolante (INS4) disposée sur la première électrode (ELT1), la deuxième électrode (ELT2) et une zone de la diode électroluminescente (LD) ; et
une cinquième couche isolante (INS5) configurée pour recouvrir la première électrode de contact (CNE1) et incluant une extrémité interposée entre la première électrode de contact (CNE1) et la deuxième électrode de contact (CNE2).

8. Dispositif électroluminescent selon la revendication 1, comprenant en outre une sixième couche isolante (INS6) partiellement disposée sur la première électrode (ELT1), la deuxième électrode (ELT2) et une zone de la diode électroluminescente (LD), et configurée pour exposer une zone de chacune de la première (ELT1) et de la deuxième électrodes (ELT2), ainsi que la première extrémité (EP1) et la deuxième extrémité (EP2) de la diode électroluminescente (LD), éventuellement, dans lequel :
une extrémité de la première électrode de contact (CNE1) est disposée sur une zone de la sixième couche isolante (INS6) qui est disposée sur la diode électroluminescente (LD) ; et
dans lequel une extrémité de la deuxième électrode de contact (CNE2) est disposée, face à la première électrode de contact (CNE1), sur la zone de la sixième couche isolante (INS6) qui est disposée sur la diode électroluminescente (LD).

9. Dispositif électroluminescent selon l'une quelconque des revendications 1, ou 4 à 8, comprenant en outre au moins une couche d'encapsulation (ENC) configurée pour recouvrir une surface du substrat (SUB) sur laquelle sont disposées la première électrode de contact (CNE1) et la deuxième électrode de contact (CNE2).

10. Dispositif électroluminescent selon l'une quelconque des revendications 1 à 9, dans lequel la diode électroluminescente (LD) comprend une diode électroluminescente de type à tige orientée horizontalement entre la première électrode (ELT1) et la deuxième électrode (ELT2).

11. Procédé de fabrication d'un dispositif électroluminescent, comprenant :
la formation d'une première électrode (ELT1) sur un substrat (SUB) ;
la formation d'une première couche isolante (INS1) sur le substrat (SUB) pour recouvrir au moins la première électrode (ELT1) ;
la formation d'une deuxième électrode (ELT2) sur la première couche isolante (INS1) dans une position espacée de la première électrode (ELT1) d'une distance prédéterminée ;
la fourniture d'une diode électroluminescente (LD) sur le substrat (SUB) incluant la première électrode (ELT1) et la deuxième électrode (ELT2), et l'alignement de la diode électroluminescente (LD) entre la première électrode (ELT1) et la deuxième électrode (ELT2) ;
la formation d'une première électrode de contact (CNE1) reliant électriquement une première extrémité (EP1) de la diode électroluminescente (LD) à la première électrode (ELT1), et une deuxième électrode de contact (CNE2) reliant électriquement une deuxième extrémité (EP2) de la diode électroluminescente (LD) à la deuxième électrode (ELT2) ;
la formation d'une première paroi de séparation (PW1) entre le substrat (SUB) et une zone de la première électrode (ELT1) ; et
la formation d'une deuxième paroi de séparation (PW2) entre le substrat (SUB) et une zone de la deuxième électrode (ELT2).

12. Procédé selon la revendication 11, dans lequel
(i) la formation de la première électrode de contact (CNE1) comprend :
la formation d'une première partie de contact (CNT1) en gravant la première couche isolante (INS1) de sorte qu'une zone de la première électrode (ELT1) soit exposée ; et
la formation de la première électrode de contact (CNE1) sur au moins ladite zone de la première électrode (ELT1) incluant la première partie de contact (CNT1) et sur la première extrémité (EP1) de la diode électroluminescente (LD) ; et/ou
(ii) la formation de la deuxième électrode de contact (CNE2) comprend la formation de la deuxième électrode de contact (CNE2) sur au moins une zone de la deuxième électrode (ELT2) et la deuxième extrémité (EP2) de la diode électroluminescente (LD).

13. Procédé selon la revendication 11 ou 12, dans lequel :
(i) la première électrode de contact (CNE1) et la deuxième électrode de contact (CNE2) sont formées séquentiellement sur le substrat (SUB), ou la première électrode de contact (CNE1) et la deuxième électrode de contact (CNE2) sont formées simultanément sur le substrat (SUB) ; et/ou
(ii) le procédé comprend en outre, après la formation de la deuxième électrode (ELT2), la formation d'une troisième couche isolante (INS3) configurée pour recouvrir la deuxième électrode (ELT2),
dans lequel la diode électroluminescente (LD) est déposée sur le substrat (SUB) sur lequel est formée la troisième couche isolante (INS3).

14. Dispositif d'affichage comprenant :
le dispositif électroluminescent selon les revendications 1 à 10.
